# EUROPEAN PATENT APPLICATION

(11) **EP 4 835 127 A1**
(43) Date of publication of application: **04.11.2026**
(21) Application number: 24912762.2
(22) Date of filing: 23.12.2024
(51) Int. Cl.: C23C 14/08, C23C 14/34

(54) **METHOD FOR PRODUCING DELAFOSSITE-TYPE OXIDE THIN FILM, AND OXIDE THIN FILM**

(30) Priority: 27.12.2023 JP 2023221816
(71) Applicant: Tanaka Precious Metal Technologies Co., Ltd., Tokyo 103-0025 (JP); National Institute for Materials Science, Tsukuba-shi, Ibaraki 305-0047 (JP)
(72) Inventor: HARADA, Takayuki, Tsukuba-shi, Ibaraki 305-0047 (JP); MASAHIRO, Yasushi, Isehara-shi, Kanagawa 259-1146 (JP); KAMA, Yasunori, Isehara-shi, Kanagawa 259-1146 (JP)
(74) Representative: Scott, Stephen John
(86) International application number: PCT/JP2024/045554
(87) International publication number: WO 2025/142875

(57) **Abstract**

A method of producing a delafossite-type oxide thin film and an oxide thin film having a delafossite-type crystal structure are provided. The method of producing a delafossite-type oxide thin film includes a film formation process of forming a thin film by physical vapor deposition using a target containing a first metal and a second metal. The first metal is palladium or platinum, and the second metal is cobalt, chromium, or rhodium.

## Description

### TECHNICAL FIELD

The present disclosure relates to a method of producing a delafossite-type oxide thin film, and an oxide thin film.

### BACKGROUND

In Patent Literature (PTL) 1, a sputtering target made of cobalt or a cobalt-based alloy and a method of producing same are described. This target has an average PTF (leakage magnetic flux) of 75 % or more in the direction perpendicular to the sputtering surface and a standard deviation of the PTF in the direction perpendicular to the sputtering surface is 5 % or less, when measured at a thickness of 3 mm. This target has a composition consisting of Co and inevitable impurity, or containing one or more elements selected from the group consisting of Pt, Cr, Ni, Fe, Pd, Ir, Ru, B, Si, Ge, Mn, Ti, Zr, V, and Ta. Further, this production method includes a process of preparing a raw material powder having a composition consisting of Co and inevitable impurity, or containing one or more elements selected from the group consisting of Pt, Cr, Ni, Fe, Pd, Ir, Ru, B, Si, Ge, Mn, Ti, Zr, V, and Ta, wherein the content of each element is Pt: 5 mass% or less, Cr: 5 mass% or less, Ni: 25 mass% or less, Fe: 9 mass% or less, Pd: 25 mass% or less, Ir: 25 mass% or less, Ru: 25 mass% or less, B: 0.5 mass% or less, Si: 2 mass% or less, Ge: 18 mass% or less, Mn: 25 mass% or less, Ti: 2 mass% or less, Zr: 1 mass% or less, V: 1.5 mass% or less, and Ta: 3 mass% or less, with the balance being Co and inevitable impurity, and having a D10 of 10 µm or more and a D90 of 150 µm or less on a volume basis as determined by a laser diffraction method, and a process of forming the raw material powder into a desired target shape to be fabricated by an additive manufacturing method under conditions of a preheating temperature of 600 °C to 900 °C, an electron beam accelerating voltage of 50 kV to 70 kV, a build layer thickness of 50 µm/layer to 100 µm/layer, and a beam scan speed of 500 m/s to 5000 m/s. This production method cites powder bed fusion (PBF) as an example of additive manufacturing, in which an additive manufacturing process is carried out by repeatedly heating the surface of a powder bed using electron beam melting (EBM) or laser melting (SLM), thereby selectively melting and solidifying the powder.

In PTL 2, a method of producing a sputtering target material is described. This production method is method of producing a sputtering target material composed of a magnetic alloy obtained by hot consolidation molding of a powder, using a powder raw material composed of at least one element selected from the element group consisting of Fe, Co, and Ni, which are elements in period 4 of Group 8A of the periodic table, or at least one element selected from the element group consisting of Fe, Co, and Ni, which are elements in period 4 of Group 8A of the periodic table, in a total amount of 60 at% or more as the main component, with the balance being at least one element selected from the element group consisting of Al, Ag, Au, B, C, Ce, Cr, Cu, Ga, Ge, Dy, Gd, Hf, In, La, Mn, Mo, Nb, Nd, P, Pd, Pt, Ru, Si, Sm, Sn, Ta, Ti, V, W, Y, Zn, and Zr, and inevitable impurity. The sputtering target material is produced by hot consolidation molding of the powder and then cooling to 300 °C at a cooling rate of 144 °C/h to 36,000 °C/h. In PTL 2, a target is described as containing Co as the main component and 1 at% Pd, and a target is described as containing Co as the main component and 1 at% Pt.

For example, as described in PTL 3, demand for power devices (also referred to as power semiconductors, power elements, or power semiconductor elements) used in electrical power converters such as inverters and converters is increasing due to, for example, the spread of electric vehicles (EVs). Gallium oxide, for example, is known as an oxide for use in power devices.

In Non-Patent Literature (NPL) 1, an example is described where a large Schottky barrier of 1.8 eV was realized in a PdCoO₂ thin film. The PdCoO₂ thin film was produced by pulsed laser deposition. NPL 1 illustrates that, at an interface between PdCoO₂ and a thermally stable oxide, such as the interface between PdCoO₂ and β-Ga₂O₃, a polar layered electric dipole is naturally formed, and therefore current rectification can be achieved with a large on/off ratio approaching the order of 10⁸ even in a high-temperature environment, for example, at 350 °C. Further, NPL 1 describes that there is a great demand in the technical fields of automobiles, plants, and aerospace for semiconductor devices to operate at high temperatures for switching and sensing applications.

### CITATION LIST

### Patent Literature

PTL 1: JP 2017-119904 A
PTL 2: JP 2011-208265 A
PTL 3: WO 2020/090491 A1

### Non-Patent Literature

NPL 1: Electric dipole effect in PdCoO2/β-Ga2O3 Schottky diodes for high-temperature operation, Harada et al., Science Advances 5, eaax5733 (2019)

### SUMMARY

### (Technical Problem)

As described in PTL 3, gallium oxide has a large band gap, a large dielectric breakdown field, and also has high thermal stability and excellent chemical resistance, making it an excellent semiconductor for power devices. Demand for gallium oxide in power device applications is expected to increase. However, conventional Schottky electrodes using platinum have, for example, a small Schottky barrier, and are therefore insufficient in terms of heat resistance and reliability (voltage resistance) in applications where excellent semiconductors for power devices such as gallium oxide are used, for example applications requiring high output.

Here, as described in NPL 1, palladium cobalt oxide (PdCoO₂) and delafossite-type oxides similar to palladium cobalt oxide, such as palladium chromium oxide (PdCrO₂), palladium rhodium oxide (PdRhO₂), and platinum cobalt oxide (PtCoO₂), exhibit high electrical conductivity comparable to that of elemental metals such as gold, silver, and copper, despite being oxides. Accordingly, they are expected to be useful, for example, as excellent Schottky electrodes for power devices such as gallium oxide.

In a semiconductor device, an electrode is formed by depositing an electrode material by, for example, sputtering. Therefore, as described in PTL 1 and PTL 2, for example, sputtering targets suitable for producing desired thin films have been investigated. However, PTL 1 and PTL 2 do not describe the formation of a delafossite-type oxide thin film. Accordingly, it is desirable to provide a new method of producing a delafossite-type oxide thin film. Further, it is desirable to provide a method of producing a delafossite-type oxide thin film having high electrical conductivity.

The present disclosure is made in view of the above circumstances, and it would be helpful to provide a method of producing a delafossite-type oxide thin film and an oxide thin film that has a delafossite-type crystal structure and high electrical conductivity.

### (Solution to Problem)

In order to achieve the above, a method of producing a delafossite-type oxide thin film according to the present disclosure comprises:
a film formation process of forming a thin film by physical vapor deposition using a target containing a first metal and a second metal,
wherein
   the first metal is palladium or platinum, and
   the second metal is cobalt, chromium or rhodium.

In order to achieve the above, an oxide thin film according to the present disclosure comprises:
a delafossite-type crystal structure, and has a residual resistivity ratio, which is a value obtained by dividing the electrical resistivity at 300 K by the electrical resistivity at 2 K, of 1.0 or more and 8.0 or less.

In order to achieve the above, an oxide thin film according to the present disclosure comprises:
a delafossite-type crystal structure, and when a number of A-site layers in the thickness direction is N, regions having the same N account for 33 % or more of the area of the thin film.

In order to achieve the above, an oxide thin film according to the present disclosure comprises:
a delafossite-type crystal structure, wherein triangular or hexagonal crystal facets appear on the surface, and the root mean square of surface roughness height is 0.4 nm or less.

### (Advantageous Effect)

According to the present disclosure, it is possible to provide a method of producing a delafossite-type oxide thin film and an oxide thin film having a delafossite-type crystal structure and high electrical conductivity.

### BRIEF DESCRIPTION OF THE DRAWINGS

In the accompanying drawings:
FIG. 1 is a mapping image of palladium in a target according to Example 1, obtained by SEM-EDX;
FIG. 2 is a mapping image of cobalt in a target according to Example 1, obtained by SEM-EDX;
FIG. 3 is a mapping image of palladium in a target according to Example 2, obtained by SEM-EDX;
FIG. 4 is a mapping image of cobalt in a target according to Example 2, obtained by SEM-EDX;
FIG. 5 is an X-ray diffraction pattern of a thin film according to condition 1;
FIG. 6 is an X-ray diffraction pattern of a thin film according to condition 2;
FIG. 7 is an X-ray diffraction pattern of a thin film according to condition 3;
FIG. 8 is an X-ray diffraction pattern of a thin film according to condition 4;
FIG. 9 is an X-ray diffraction pattern of a thin film according to condition 5;
FIG. 10 is an X-ray diffraction pattern of a thin film according to condition 6;
FIG. 11 is an X-ray diffraction pattern of a thin film according to condition 7;
FIG. 12 is an X-ray diffraction pattern of a thin film according to condition 8;
FIG. 13 is an X-ray diffraction pattern of a thin film according to condition 9;
FIG. 14 is an X-ray diffraction pattern of a thin film according to condition 10;
FIG. 15 is an X-ray diffraction pattern of a thin film according to condition 11;
FIG. 16 is an X-ray diffraction pattern of a thin film according to condition 12;
FIG. 17 is an X-ray diffraction pattern of a thin film according to condition 13;
FIG. 18 is an X-ray diffraction pattern of a thin film according to condition 14;
FIG. 19 is an X-ray diffraction pattern of a thin film according to condition 8 after heat treatment;
FIG. 20 is an X-ray diffraction pattern of a thin film according to condition 15;
FIG. 21 is an X-ray diffraction pattern of a thin film according to condition 16;
FIG. 22 is an X-ray diffraction pattern of a thin film according to condition 17;
FIG. 23 is an X-ray diffraction pattern of a thin film according to condition 18;
FIG. 24 is an X-ray diffraction pattern of a thin film according to condition 19;
FIG. 25 is an X-ray diffraction pattern of a thin film according to condition 20;
FIG. 26 is an X-ray diffraction pattern of a thin film according to condition 21;
FIG. 27 is an X-ray diffraction pattern of a thin film according to condition 22;
FIG. 28 is an X-ray diffraction pattern of a thin film according to condition 23;
FIG. 29 is an X-ray diffraction pattern of a thin film according to condition 24;
FIG. 30 is an X-ray diffraction pattern of a thin film according to condition 25;
FIG. 31 is an X-ray diffraction pattern of a thin film according to condition 26;
FIG. 32 is an X-ray diffraction pattern of a thin film according to condition 27;
FIG. 33 is an X-ray diffraction pattern of a thin film according to condition 28;
FIG. 34 is an X-ray diffraction pattern of a thin film according to condition 29;
FIG. 35 is an X-ray diffraction pattern of a thin film according to condition 31;
FIG. 36 is an X-ray diffraction pattern of a thin film according to condition 32;
FIG. 37 is an X-ray diffraction pattern of a thin film according to condition 33;
FIG. 38 is an X-ray diffraction pattern of a thin film according to condition 34;
FIG. 39 is an SEM image (500,000 magnification) of a thin film according to condition 23;
FIG. 40 is an SEM image (2,000,000 magnification) of a thin film according to condition 23;
FIG. 41 is an SEM image (500,000 magnification) of a thin film according to condition 24;
FIG. 42 is an SEM image (2,000,000 magnification) of a thin film according to condition 24;
FIG. 43 is an SEM image (500,000 magnification) of a thin film according to condition 25;
FIG. 44 is an SEM image (2,000,000 magnification) of a thin film according to condition 25;
FIG. 45 is an SEM image (500,000 magnification) of a thin film according to condition 26;
FIG. 46 is an SEM image (2,000,000 magnification) of a thin film according to condition 26;
FIG. 47 is an SEM image (500,000 magnification) of a thin film according to condition 27;
FIG. 48 is an SEM image (2,000,000 magnification) of a thin film according to condition 27;
FIG. 49 is a graph obtained by investigating a relationship between pressure during film formation and peak intensity ratio;
FIG. 50 is a schematic diagram of a PtCoO₂/PdCoO₂ stacked thin film fabricated on an Al₂O₃ substrate;
FIG. 51 is an X-ray diffraction pattern of a thin film according to condition 35;
FIG. 52 is an X-ray diffraction pattern of a thin film according to condition 36;
FIG. 53 is an X-ray diffraction pattern of a thin film according to condition 37;
FIG. 54 is an enlarged view of the X-ray diffraction pattern of the thin film according to condition 37;
FIG. 55 is an X-ray diffraction pattern of a thin film according to condition 38;
FIG. 56 illustrates X-ray diffraction patterns of thin films according to conditions 39 and 44;
FIG. 57 is an enlarged view of the X-ray diffraction pattern of the thin film according to condition 39;
FIG. 58 illustrates X-ray diffraction patterns of thin films according to conditions 40 and 44;
FIG. 59 is an enlarged view of the X-ray diffraction pattern of the thin film according to condition 40;
FIG. 60 is an X-ray diffraction pattern of a thin film according to condition 41;
FIG. 61 is an X-ray diffraction pattern of a thin film according to condition 42;
FIG. 62 is an X-ray diffraction pattern of a thin film according to condition 43;
FIG. 63 is a diagram comparing an X-ray diffraction pattern of a thin film according to condition 31 with simulation results using the Laue function; and
FIG. 64 is an atomic force microscope image according to condition 31.

### DETAILED DESCRIPTION

The following describes a method of producing a delafossite-type oxide thin film and an oxide thin film according to embodiments of the present disclosure. First, an outline of the method of producing a delafossite-type oxide thin film according to the present embodiment is described.

The method of producing a delafossite-type oxide thin film according to the present embodiment includes a film formation process of forming a thin film by physical vapor deposition using a target containing a first metal and a second metal. The first metal is palladium or platinum and the second metal is cobalt, chromium, or rhodium.

The oxide thin film according to the present embodiment has a delafossite-type crystal structure, and has a residual resistivity ratio, which is a value obtained by dividing the electrical resistivity at 300 K by the electrical resistivity at 2 K, of 1.0 or more and 8.0 or less.

The oxide thin film according to the present embodiment has a delafossite-type crystal structure, and when a number of A-site layers in the thickness direction is N, regions having the same N account for 33 % or more of the area of the thin film. The oxide thin film according to the present embodiment can realize a delafossite-type oxide thin film having high electrical conductivity (high residual resistivity ratio).

The oxide thin film according to the present embodiment has a delafossite-type crystal structure, and triangular or hexagonal crystal facets appear on the surface, and the root mean square of surface roughness height in the thickness direction is 0.4 nm or less. The oxide thin film according to the present embodiment has such good crystallinity that triangular or hexagonal crystal facets appear on the surface, and can realize a delafossite-type oxide thin film having high electrical conductivity (high residual resistivity ratio).

The method of producing a delafossite-type oxide thin film according to the present embodiment is described in detail below.

Delafossite-type oxides are oxides represented by the general formula ABO₂. According to the present embodiment, when simply referring to a delafossite-type oxide, this includes at least palladium cobalt oxide (PdCoO₂), palladium chromium oxide (PdCrO₂), platinum cobalt oxide (PtCoO₂), and palladium rhodium oxide (PdRhO₂) having a delafossite-type crystal structure.

The target contains the first metal and the second metal. The first metal is element A (monovalent cation) in the above general formula. The second metal is element B (trivalent cation) in the above general formula. The target may contain impurity.

The first metal is palladium (Pd) or platinum (Pt). The target contains the first metal in an amount of 45 at% or more and 90 at% or less. The target preferably contains 45 at% or more and 60 at% or less, and more preferably 50 at% or more and 55 at% or less, of the first metal. Hereinafter, "at%" indicates the element ratio expressed in %.

The second metal is cobalt (Co), chromium (Cr), or rhodium (Rh). The target contains the second metal in an amount of 10 at% or more and 55 at% or less. The target preferably contains 40 at% or more and 55 at% or less, and more preferably 45 at% or more and 50 at% or less, of the second metal.

When the target contains the first metal and the second metal in a ratio described above, the target according to the present embodiment becomes suitable for producing a delafossite-type oxide thin film (hereinafter, sometimes referred to simply as a thin film). Specifically, when a thin film is produced by physical vapor deposition (hereinafter sometimes referred to as PVD) using this target, the proportion of delafossite-type oxide in the thin film can be increased. In other words, the proportion of metals and metal oxides other than the delafossite-type oxide in the thin film can be decreased.

By decreasing the proportion of metals or metal oxides other than the delafossite-type oxide, the electrical resistivity of the thin film when used as an electrode can be decreased, making the thin film more suitable for use as an electrode.

According to the present embodiment, impurity refers to an elements or elements that are not intentionally added. The target has an impurity content controlled to 500 mass ppm or less (hereinafter sometimes referred to simply as ppm). The content of impurity contained in the target is preferably controlled to 300 ppm or less, and more preferably 200 ppm or less, per element. That is, the total amount of impurity contained in the target is 500 mass ppm or less, and the content of each impurity element is 300 ppm or less, preferably 200 ppm or less. According to the present embodiment, impurity concentration is a value measured using an ICP emission spectrometer.

The target may contain impurity such as oxygen (O), nitrogen (N), carbon (C), sulfur (S), and other inevitable impurity. Of these, oxygen is controlled to 200 ppm or less. By decreasing the oxygen content, it may be possible to decrease the content of metal oxides other than the delafossite-type oxide in the thin film.

The target may be a sintered body of a metal powder containing the first metal and the second metal. The metal powder may be a mixed powder of a powder of the first metal and the powder of a second metal, or may be a powder of an alloy of the first metal and the second metal (hereinafter referred to as an alloy powder). The metal powder is preferably an alloy powder.

When the target is a sintered body, the thin film can be made homogeneous by using an alloy powder as the metal powder. Specifically, the homogeneity of the thin film means that the distribution of the delafossite-type oxide in the thin film is homogeneous, or the distribution of the constituent elements in the thin film is homogeneous, or the distribution of impurity is homogeneous. In other words, the thin film is homogeneous when, for example, the element distribution in the thin film is mapped using a scanning electron microscope (SEM) and energy dispersive X-ray spectrometry (EDX), and the variation in element distribution indicates that the elements are present in a solid solution state.

Here, the variation in element distribution is a noise level variation, for example, when a cross-section of the target is mapped using SEM-EDX and the size of the domain of the first metal is 5 µm or less in circle equivalent diameter. According to the present embodiment, the domain of the first metal is defined as a closed region on the side where the element ratio of the second metal is lower than a defined element ratio of the second metal (50 at% according to the present embodiment) when an image in which the second metal is mapped is binarized using the threshold value of the defined element ratio for the second metal. The size of this domain is preferably 5 µm or less in terms of the circle equivalent diameter converted from the area. The size of the domain is more preferably 3 µm or less, and even more preferably 1 µm or less.

The target preferably has a density of 90 % or more and 99 % or less. When the target has a low density, that is, when there are many voids inside the target, and particularly when the voids are large, this can cause abnormal discharge during PVD processes such as sputtering, resulting in particles getting mixed into the thin film during film formation (when the thin film is formed). By increasing the density to this level, particles getting mixed into the thin film during film formation by PVD is suppressed. This makes the thin film more suitable as an electrode. The density is a value calculated based on the density of the alloy of the first metal and the second metal (hereinafter referred to as alloy density) calculated based on the content ratio of the first metal and the second metal, and the apparent density of the target (hereinafter referred to as target density). That is, the density (%) is the target density divided by the alloy density and multiplied by 100. The target density is a value obtained by dividing the mass of the target by the shape (volume) of the target.

When the target is produced as a sintered body, metal powder containing 45 at% or more and 90 at% or less of the first metal, with the balance being the second metal and impurity, may be sintered. When the target according to the present embodiment is produced as a sintered body, metal powder containing the first metal preferably in an amount of 45 at% to 60 at%, more preferably 50 at% to 55 at%, may be sintered.

During this sintering, when the metal powder is an alloy powder containing 45 at% or more and 90 at% or less of the first metal, with the balance being the second metal and impurity, the target can be produced as a sintered body of the alloy powder. This makes it possible to decrease concentration variations (element ratio variations, distribution variations) between the first metal and the second metal in the target. By decreasing the concentration variation of the first metal and the second metal in the target, the thin film can be made homogeneous.

When a mixed powder of a powder of the first metal and a powder of the second metal is used as the metal powder during sintering, the target can be produced as a sintered body of the mixed powder.

The particle size of the metal powder used for sintering is preferably 20 µm or more and 120 µm or less, more preferably 50 µm or more and 70 µm or less, in terms of volume average diameter. Alternatively, the metal powder may be a product that has passed through a sieve with an aperture size of 106 µm. When the particle size of the metal powder falls within this range, it becomes easy to produce a target with high density. According to the present embodiment, the particle size and particle size distribution of the metal powder are measured using a laser diffraction particle size distribution analyzer (produced by Shimadzu Corporation, model: SLDA-2300) while the metal powder is dispersed in water containing a surfactant.

In particular, when the metal powder used for sintering is a mixed powder, the particle size of each of the first metal powder and the second metal powder is preferably 20 µm or more and 120 µm or less in terms of volume average diameter. This may decrease concentration variations (element ratio variations, distribution variations) between the first metal and the second metal in the target. By decreasing the concentration variation of the first metal and the second metal in the target, the thin film can be made homogeneous.

The sintering process of sintering the metal powder may be carried out according to the procedure described below.

The sintering process may include a compacting process in which the metal powder is formed into a defined shape, for example a disk suitable for use as a target. In the sintering process, for example, the metal powder is heated and pressurized, so that the metal powder can be sintered while being molded into a defined shape.

In the sintering process, the metal powder may be sintered at a temperature of 550 °C or higher and 1300 °C or lower. Further, in the sintering process, the metal powder may be sintered while applying a pressure of 30 MPa or more and 70 MPa or less. This makes it possible to obtain a target with a high density, specifically a density of 90 % or more and 99 % or less, as a sintered body.

The above-described target is suitable for producing a delafossite-type oxide thin film by a physical vapor deposition method (PVD method, hereinafter sometimes referred to simply as PVD) such as sputtering.

According to the present embodiment, the PVD method in the film formation process includes evaporation, ion plating, ion beam deposition, and sputtering. As the PVD method in the film formation process, sputtering is particularly preferred.

Among sputtering methods, RF sputtering, in which a high frequency AC voltage is applied to a target and a chamber containing the target, and DC sputtering, in which a DC voltage is applied to a target and a chamber containing the target, are preferred. Further, RF sputtering and DC sputtering are preferably so-called reactive sputtering methods. In the following, as an example of the sputtering, a case is described where reactive sputtering is used, in which a target reacts with oxygen.

In the film formation process, when a thin film is formed (deposited) by RF sputtering, the sputtering conditions are as follows.

The pressure of the atmosphere during film formation is preferably 0.5 Pa or less. The pressure of the atmosphere during film formation is more preferably 0.3 Pa or less. This makes it possible to further increase the proportion of delafossite-type oxide in the thin film.

The atmosphere during film formation preferably contains oxygen. In particular, the atmosphere during film formation preferably has a ratio of oxygen to inert gas (hereinafter sometimes referred to as O₂/Ar ratio) of 2 or more and 7 or less. This makes it possible to further increase the proportion of delafossite-type oxide in the thin film. Here, the inert gas may be any gas that does not easily react with other elements, such as a rare gas element or nitrogen gas, and an example of argon use is described below.

During film formation, the temperature of the substrate on which the thin film is formed is 500 °C or higher and 850 °C or lower, preferably 610 °C or higher and 800 °C or lower. This makes it possible to further increase the proportion of delafossite-type oxide in the thin film. As a substrate for forming a thin film, for example, an Al₂O₃ (0001) substrate can be used.

The thin film formed in the film formation process may then be heat-treated. This heat treatment makes the thin film highly crystalline. The atmosphere for this heat treatment is preferably the same as the atmosphere used during film formation. This makes it possible to suppress decomposition of the delafossite-type oxide in the thin film.

### EXAMPLES

### (Production Example 1)

The target according to Production Example 1 was produced as follows.

An alloy powder produced by gas atomization (produced by Tanaka Kikinzoku Kogyo K.K., volume-average particle diameter: 60 µm), which had a composition ratio (element ratio) of palladium and cobalt of 50:50 (palladium and cobalt content of approximately 50 at% each), with the balance being cobalt and impurity (impurity amount of 351 ppm or less, oxygen 25 ppm), was weighed out in an amount of 93 g and filled into a mold as powder for sintering, followed by hot-press sintering (the atmosphere during sintering was 5 × 10⁻² Pa or less), in which pressure was applied. The alloy powder was prepared by weighing palladium and cobalt (both metals) so that the alloy composition ratio (element ratio) of palladium to cobalt was 50:50, heating to 1500 °C or higher to form a molten alloy, gas atomizing the molten alloy to form atomized powder, and classifying the atomized powder using a sieve having an aperture of 106 µm.

The sintered product was then processed to obtain a disk-shaped target as the target according to this Production Example. The surface and sides of the disk of the target were polished with emery paper to prepare for subsequent use. The target after shape adjustment was a disk having a diameter of 48 mm and a thickness t of about 1.0 mm. The pressure during sintering by the hot press sintering method (pressure applied to the powder in the mold, hereinafter referred to as sintering pressure) was 50 MPa, and the temperature inside the furnace during sintering (hereinafter referred to as sintering temperature) was 700 °C. The sintering time (the time during which the sintering pressure and the sintering temperature were maintained) was 60 min. The inside of the furnace was kept under a vacuum atmosphere during sintering.

The amount of impurity in the target according to this Production Example was quantified using an ICP optical emission analyzer, and the results were 21 ppm for oxygen, 3 ppm for nitrogen, 17 ppm for carbon, and 6 ppm for sulfur. The palladium and cobalt had high purity, and a target in a metallic state (not oxidized) was obtained.

The element ratio between palladium and cobalt in the target according to this Production Example was maintained at the same element ratio as in the state of the powder (alloy powder) for sintering. Here, maintaining the element ratio as in the state of the powder for sintering means that the ratio of the element ratio of cobalt (element B) to the element ratio of palladium (element A) in the state of the powder for sintering is the same as the ratio of the element ratio of cobalt (element B) to the element ratio of palladium (element A) in the state of the target, within an error of 1 %.

The density of the target according to this Production Example was 95.9 %.

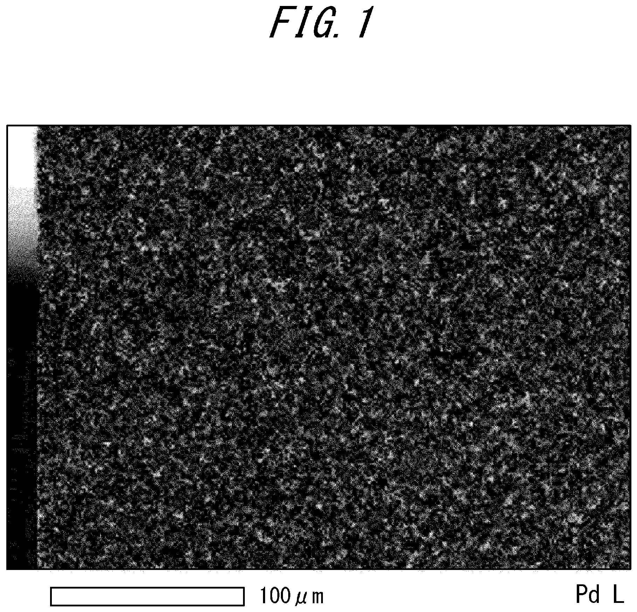

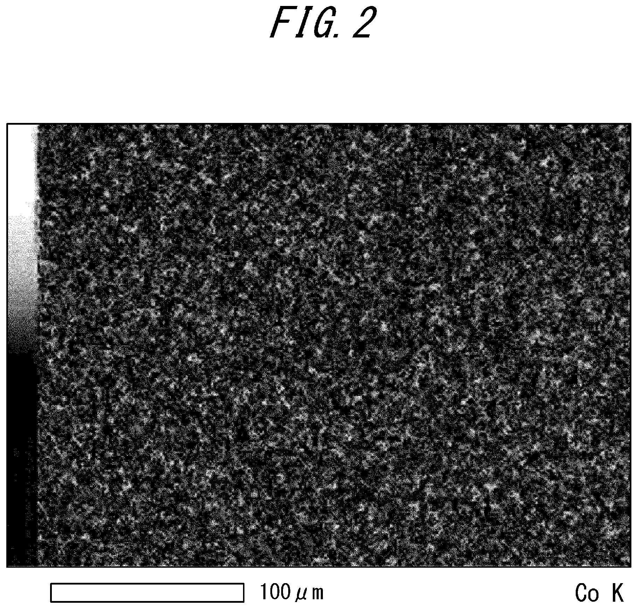

FIG. 1 and FIG. 2 illustrate a mapping image of palladium (L line) (see FIG. 1) and a mapping image of cobalt (K line) (see FIG. 2) in the target according to this Production Example, measured with SEM-EDX (produced by JEOL Ltd., model: JCM-6000Plus, magnification: 400 times). In FIG. 1 and FIG. 2, the closer to white the color, the higher the element ratio (concentration) of the element being mapped. The circle equivalent diameter of the cobalt domains measured based on FIG. 2 was 5 µm or less. In these mapping images, almost no unevenness in the concentration of palladium or cobalt was observed, and it was confirmed that the dispersion state was extremely good and that the palladium and cobalt were in a solid solution state. From this result, it was determined that the target according to this Production Example was in a homogeneously alloyed state.

### (Production Example 2)

The target of Production Example 2 differs from Production Example 1 in that a mixed powder of palladium powder and cobalt powder was used as the sintering powder instead of the alloy powder, but was otherwise produced in the same way as Production Example 1.

Palladium powder was prepared by chemical reduction (Tanaka Kikinzoku Kogyo K.K., passed through a sieve with 106 µm aperture) and had an impurity content of 245 ppm. The cobalt powder was prepared by gas atomization and had an impurity content of 246 ppm. Then, 59.85 g of palladium powder and 33.15 g of cobalt powder were weighed out, and these were mixed in a mortar for 10 min to obtain a mixed powder. Then, 93 g of the mixed powder was weighed and filled into a mold, and then a disk-shaped target was obtained in the same way as in Production Example 1. The cobalt powder was obtained by heating cobalt to 1500 °C or higher to form a molten metal, gas atomizing the molten metal to form atomized powder, and classifying the atomized powder through a sieve with 106 µm aperture.

The amount of impurity in the target according to this Production Example was 171 ppm oxygen, 40 ppm nitrogen, 27 ppm carbon, and 9 ppm sulfur. The palladium and cobalt had high purity, and a target in a metallic state (non-oxidized) was obtained.

The element ratio between palladium and cobalt in the target according to this Production Example was maintained at the same element ratio as in the state of the powder (mixed powder) for sintering.

The density of the target according to this Production Example was 95.1 %.

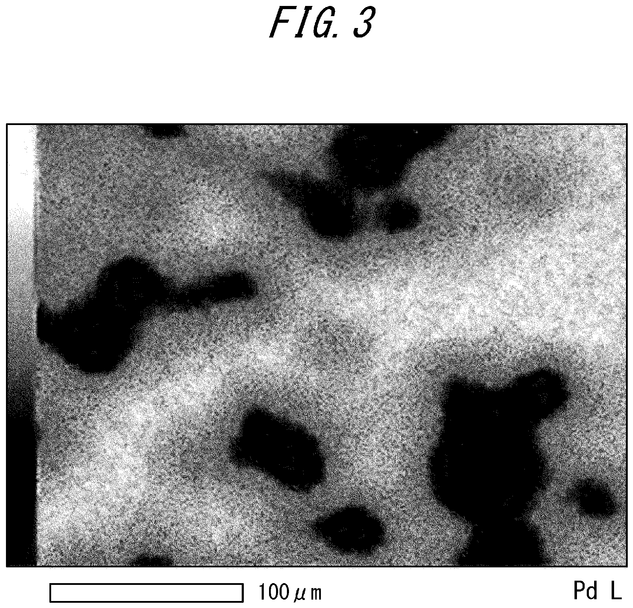

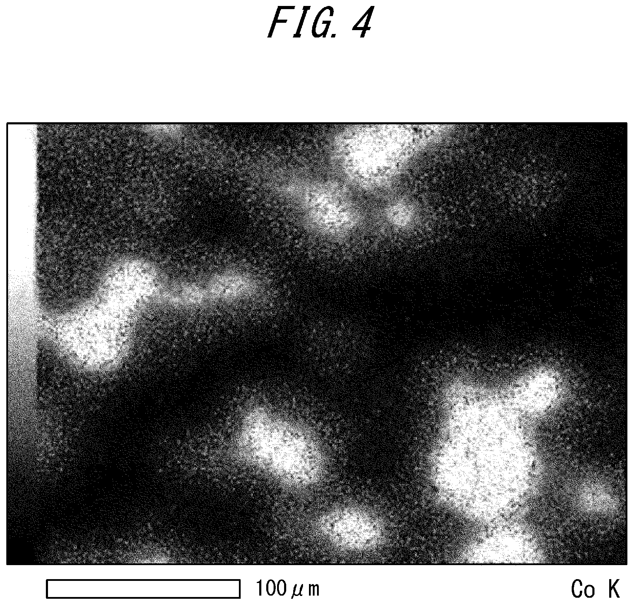

FIG. 3 and FIG. 4 illustrate a mapping image of palladium (see FIG. 3) and a mapping image of cobalt (see FIG. 4) of the target according to this Production Example, which were measured in the same way as in Production Example 1. In FIG. 3 and FIG. 4, the closer to white the color, the higher the element ratio (concentration) of the element being mapped. In these mapping images, the unevenness of the palladium and cobalt concentrations was clearly observed. It was determined that the target according to this Production Example was in a state in which parts having a high element ratio (concentration) of palladium and parts having a high element ratio (concentration) of cobalt were mixed and dispersed. Observation of these images revealed that the size of the domains having high palladium element ratios (concentrations) and the size of the domains having high cobalt concentrations roughly corresponded to the particle size of the powder used for sintering. That is, it may be considered that in a target sintered using a mixed powder, domains of each element corresponding to the particle size of the mixed powder used for sintering remain.

### (Production Example 3)

Further, using the targets of Production Examples 1 and 2, thin films of palladium cobalt oxide were formed by reactive sputtering using RF sputtering. The thin films of Production Example 3 were formed by changing the target and film formation conditions as follows.

An Al₂O₃ (sapphire) substrate (0001) was used as the substrate for forming the thin films. The substrate used had been annealed at 1100 °C for 2 h.

The sputtering was carried out using a sputtering device (model: ESCS-232S) produced by Eiko Engineering Ltd.

The RF output was set to 60W or 100W. The RF frequency was 13.56 MHz.

The pressure in the chamber where the film was formed was set to 0.10 Pa, 0.15 Pa, 0.20 Pa, 0.50 Pa, 3 Pa, or 20 Pa.

The TS distance (the distance from the target surface of the cathode of the sputtering device to the substrate) was set to 150 mm.

The reactive gas supplied to the chamber for reactive sputtering was a mixed gas of argon (Ar) and oxygen (O₂). The flow rates of the reactive gases in the chamber were 3 sccm to 5 sccm for argon and 10 sccm to 14 sccm for oxygen. The O₂/Ar ratio was set to 2.0, 3.0, 3.5, or 4.0.

An Al₂O₃ (0001) substrate was used as the substrate on which the thin film was formed. The substrate temperature during film formation was set to 470 °C, 610 °C, 700 °C, 750 °C, or 800 °C. The substrate temperature was controlled by setting the temperature of the substrate heater in the sputtering device to 500 °C, 650 °C, 750 °C, 800 °C, or 850 °C, respectively.

As described above, the target and film formation conditions were changed, and 14 thin films under conditions 1 to 14 were produced. Table 1 lists conditions 1 to 14 for producing these thin films.

**[Table 1]**

| | Target | Film formation conditions | | | | | | XRD evaluation |
|---|---|---|---|---|---|---|---|---|
| | | RF Output | Pressure | Oxygen | Argon | O₂/Ar ratio | Substrate temperature | PdCoO₂ detected |
| | | (W) | (Pa) | (sccm) | (sccm) | (-) | (°C) | |
| Condition 1 | Production Example 1 | 100 | 20 | 10 | 5 | 2.0 | 800 | no |
| Condition 2 | Production Example 1 | 100 | 0.20 | 10 | 5 | 2.0 | 800 | yes |
| Condition 3 | Production Example 1 | 100 | 0.20 | 12 | 3 | 4.0 | 800 | yes |
| Condition 4 | Production Example 1 | 100 | 0.20 | 12 | 4 | 3.0 | 800 | yes |
| Condition 5 | Production Example 1 | 100 | 0.20 | 14 | 4 | 3.5 | 800 | yes |
| Condition 6 | Production Example 1 | 60 | 0.20 | 14 | 4 | 3.5 | 800 | yes |
| Condition 7 | Production Example 1 | 60 | 0.20 | 14 | 4 | 3.5 | 750 | yes |
| Condition 8 | Production Example 1 | 60 | 0.20 | 14 | 4 | 3.5 | 700 | yes |
| Condition 9 | Production Example 1 | 60 | 0.50 | 14 | 4 | 3.5 | 700 | yes |
| Condition 10 | Production Example 2 | 60 | 0.20 | 14 | 4 | 3.5 | 700 | yes |
| Condition 11 | Production Example 2 | 60 | 0.10 | 14 | 4 | 3.5 | 700 | yes |
| Condition 12 | Production Example 2 | 60 | 0.10 | 10 | 5 | 2.0 | 700 | yes |
| Condition 13 | Production Example 1 | 60 | 0.20 | 14 | 4 | 3.5 | 610 | yes |
| Condition 14 | Production Example 1 | 60 | 0.20 | 14 | 4 | 3.5 | 470 | no |

The thin films according to conditions 1 to 14 were evaluated by X-ray diffraction (XRD). These results are listed together in Table 1.

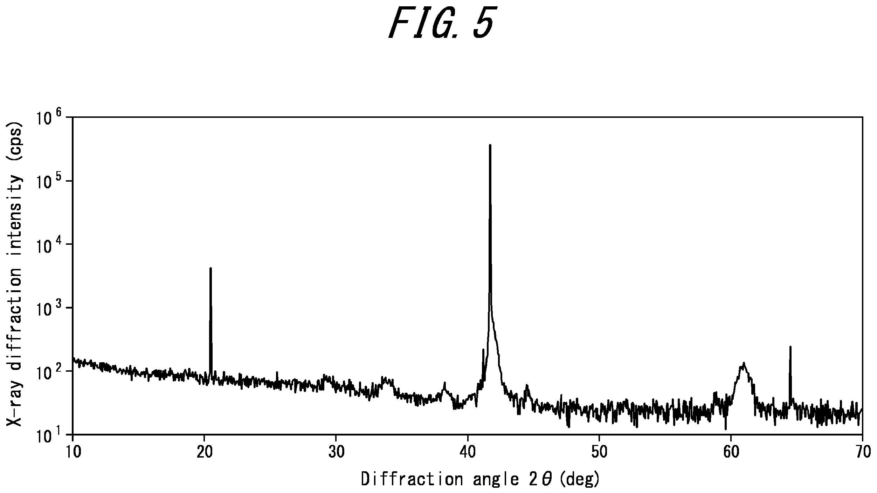

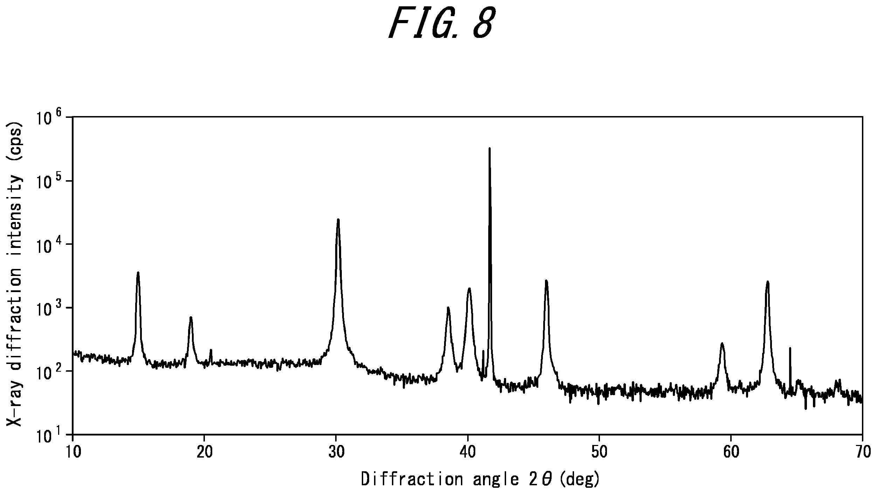

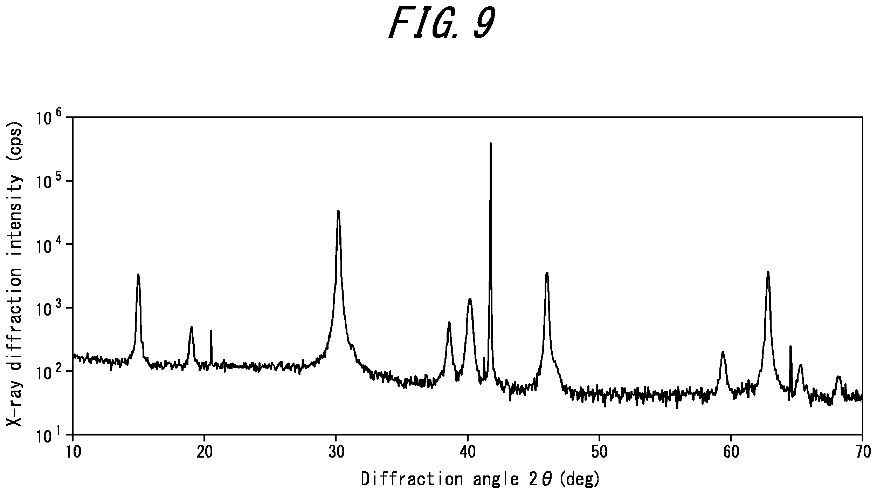

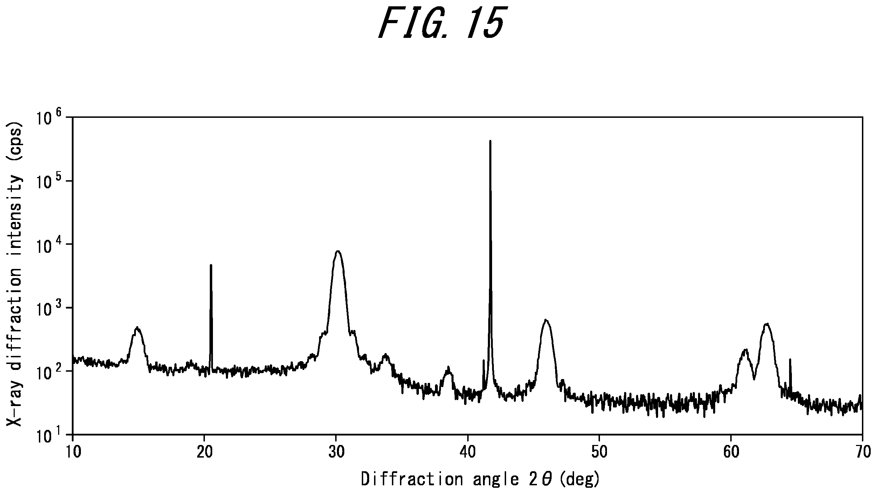

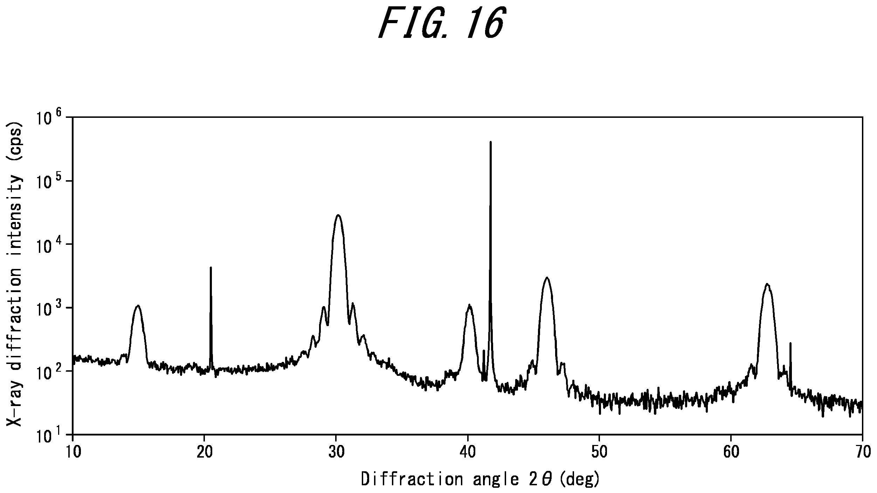

FIG. 5 to FIG. 18 illustrate X-ray diffraction patterns of the thin films according to conditions 1 to 14, in this order.

In these X-ray diffraction patterns, the peaks at diffraction angles 2θ of 15.0°, 30.2°, 46.0°, and 62.7° represent the peaks of the (0003), (0006), (0009), and (0012) planes of palladium cobalt oxide. The peak at a diffraction angle 2θ of 38.6° indicates the peak of the (222) plane of tricobalt tetroxide (Co₃O₄). The peak at a diffraction angle 2θ of 33.8° indicates the peak of the (101) plane of palladium oxide (PdO). The peak at a diffraction angle 2θ of 40.1° indicates the peak of the (111) plane of metallic palladium (Pd). The peaks at diffraction angles 2θ of 20.5°, 41.7°, and 64.5° are peaks of the Al₂O₃ substrate.

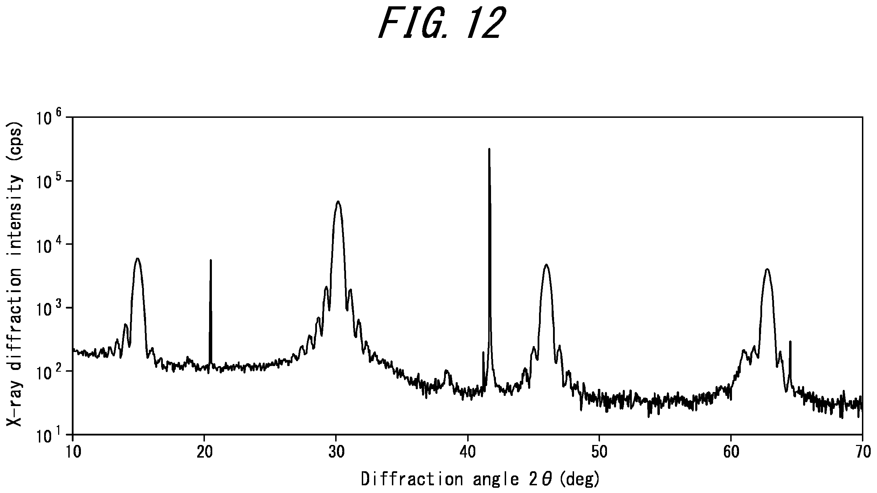

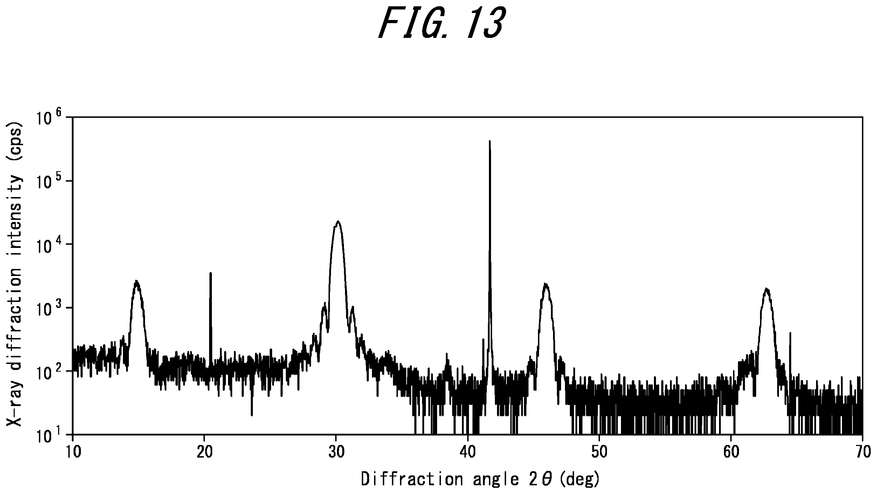

From the observation results of the X-ray diffraction patterns of the thin films under conditions 1 to 14, palladium cobalt oxide (PdCoO₂) having a delafossite-type crystal structure was detected under conditions 2 to 13. From these results, it is understood that when the atmospheric pressure during film formation is 0.50 Pa or less, it is possible to form a thin film containing palladium cobalt oxide. A palladium oxide peak was observed in the thin film according to condition 9 (see FIG. 13), but no palladium oxide peak was observed in the thin film according to condition 8 (see FIG. 12). Therefore, it is preferable that the pressure of the atmosphere during film formation is 0.20 Pa or less, as this decreases the amount of cobalt oxide in the thin film. A decrease in the atmospheric pressure during film formation increases the mean free path, which suggests the possibility that this may have decreased the amount of cobalt oxide in the thin film.

The thickness (nm) of the thin films formed under conditions 8 and 11 was determined to be 12.0 nm. The thickness of these thin films was determined based on fringes observed in the X-ray diffraction patterns of these thin films.

Further, the electrical resistivity (Qcm) at a temperature of 300 K and the electrical resistivity (Ωcm) at a temperature of 2 K were measured for the thin films under conditions 8 and 11. The electrical resistivity was determined based on the sheet resistance measured by a direct current four-terminal method after wiring with Au (gold) wires by pressure bonding In (indium) to the thin film and the above-mentioned film thickness. The electrical resistivity (Qcm) at 300 K and the electrical resistivity (Qcm) at 2 K under condition 8 were 7.74 × 10⁻⁶ and 3.80 × 10⁻⁶, respectively. The electrical resistivity (Ωcm) at 300 K and the electrical resistivity (Ωcm) at 2 K under condition 11 were 2.61 × 10⁻³ and 2.52 × 10⁻², respectively.

Further, the residual resistivity ratios (RRR) of the thin films under conditions 8 and 11 were calculated by dividing the electrical resistivity at 300 K by the electrical resistivity at 2 K. The RRR under condition 8 was 2.04. The RRR under condition 11 was 0.10. The larger the RRR value, the greater the effect of decreasing the electrical resistance in the low temperature range. The larger the RRR value, the lower the crystal defect density, which is preferable for an electrode such as a Schottky electrode for a power device.

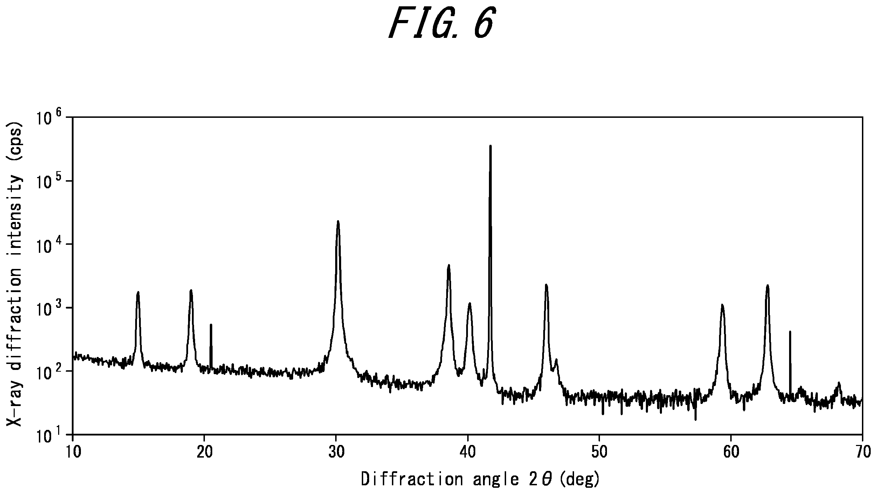

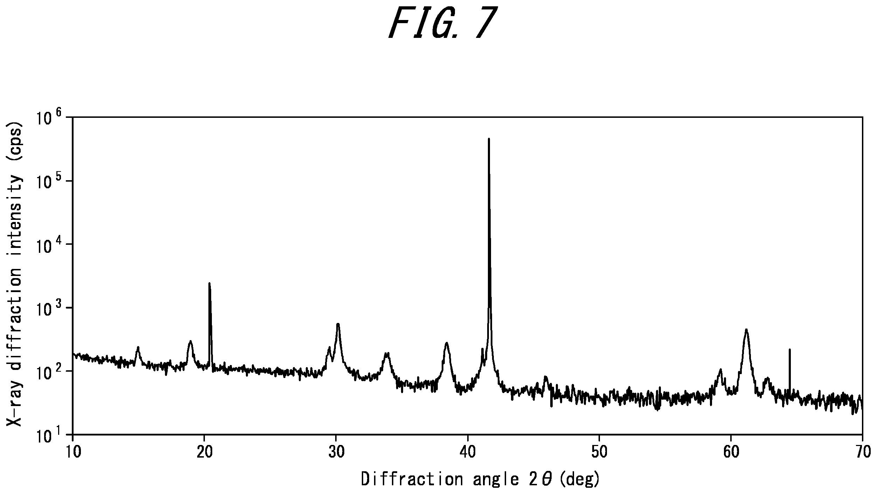

Palladium oxide was observed in the thin film under condition 3, where the O₂/Ar ratio was 4.0 (see FIG. 7), but no cobalt oxide peak was observed in the thin films under conditions 2, 4, and 5, where the O₂/Ar ratio was 3.5 or less (see FIG. 6, FIG. 8, and FIG. 9, respectively). Further, the thin film according to condition 3, in which the O₂/Ar ratio was 4.0, had a weaker peak intensity of palladium cobalt oxide than the thin films according to conditions 2, 4, and 5. Accordingly, it is clear that the O₂/Ar ratio is preferably 4.0 or less, and more preferably 3.5 or less. From the results of condition 2, it can be determined that a palladium cobalt oxide film can be formed when the O₂/Ar ratio is at least 2.0 or more.

The thin films according to conditions 2 to 5 have an RF output of 100 W, and the thin films according to conditions 6 to 9, 13, and 14 have an RF output of 60 W. However, when the substrate temperature is 500 °C or higher (conditions 6 to 9 and 13), it is possible to form a thin film containing palladium cobalt oxide with an atmospheric pressure of 0.50 Pa or less during film formation, just as in the case of an RF output of 100 W.

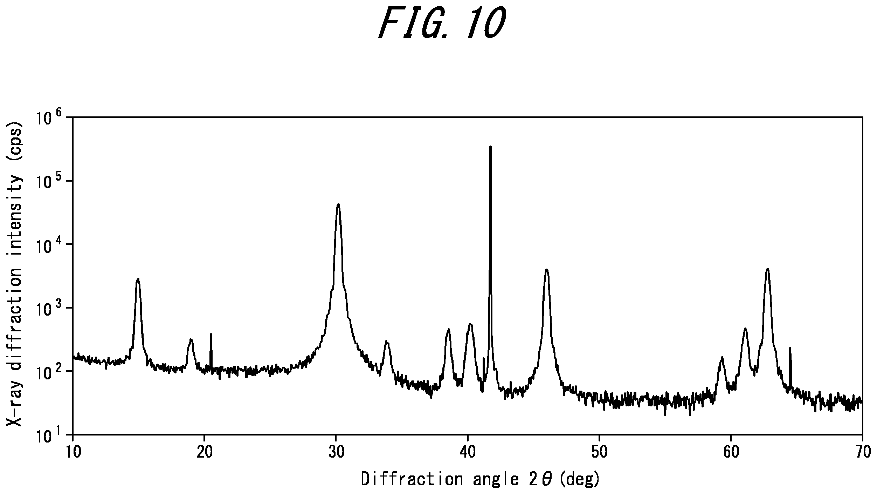

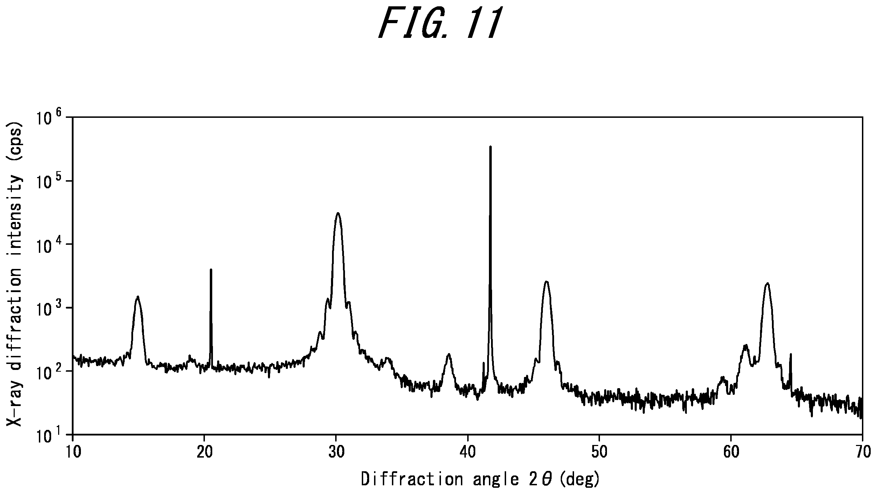

In comparing conditions 6 to 9, there is no significant difference in the thin film when the substrate temperature is in the range of 700 °C to 800 °C. This result suggests that a thin film can be formed at a substrate temperature of 500 °C or higher and 850 °C or lower. No palladium oxide peak was observed under condition 8 (see FIG. 12), but slight palladium oxide peaks were observed under conditions 6 and 7 (see FIG. 10 and FIG. 11), suggesting that a substrate temperature lower than 750 °C is preferable. Further, when comparing conditions 6 and 8, the peak of metallic cobalt was weaker when the substrate temperature was low (condition 8) than when high (condition 6), which also suggests that a substrate temperature lower than 750 °C is preferable.

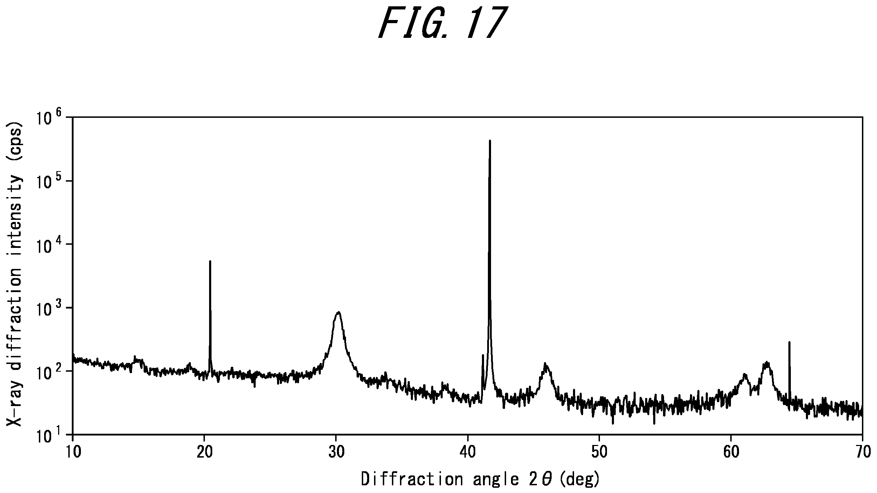

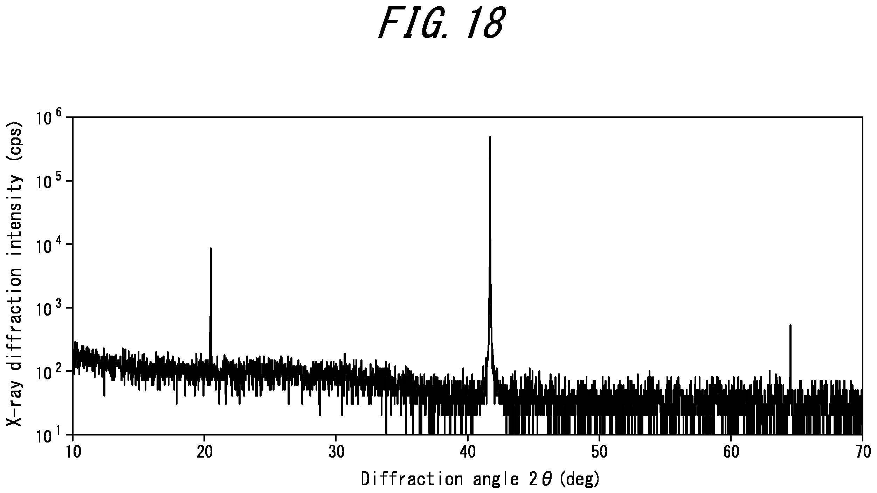

Further, taking into consideration the results of conditions 13 and 14 (see FIG. 17 and FIG. 18), it can be said that the substrate temperature is preferably 500 °C or higher.

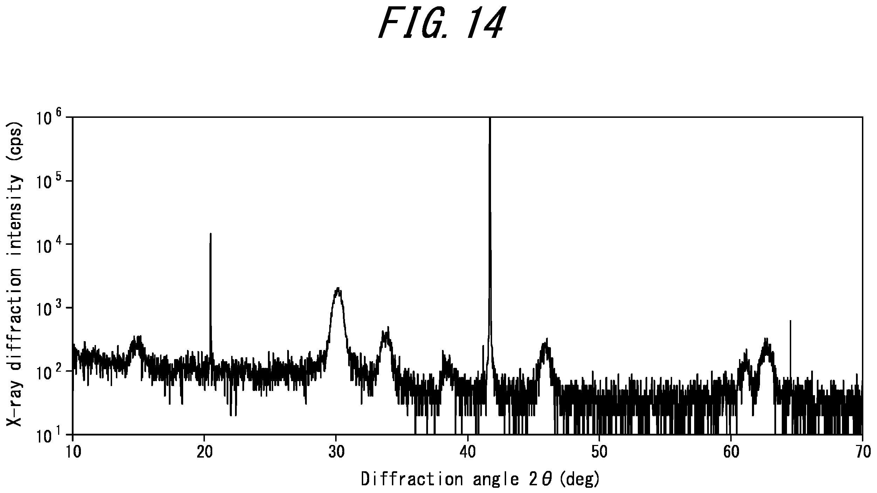

Conditions 10 to 12 are cases where a film was formed using the target of Production Example 2 (a target produced from a mixed powder of palladium powder and cobalt powder), while the other conditions use the target of Production Example 1 (a target produced from an alloy powder). The results under conditions 10 to 12 (see FIG. 14 to FIG. 16) indicate that it is possible to form a thin film containing palladium cobalt oxide even when a target produced from a mixed powder is used instead of a target produced from an alloy powder.

Further, even when a target produced from mixed powder is used as in conditions 10 to 12, it is possible to form a palladium cobalt oxide film as long as the O₂/Ar ratio is 2.0 or more and 3.5 or less.

A comparison between condition 10 (see FIG. 14) and condition 8 (see FIG. 12) reveals that the use of a target produced from alloy powder (condition 8) is preferable because the peak of palladium cobalt oxide is larger than when a target produced from mixed powder is used (condition 10).

The element ratios of palladium to cobalt in the thin films under conditions 2 to 13 were measured using an ICP emission spectrometer, and the Pd:Co ratio was in the range of 48.8:51.2 to 49.0:51.0 for all the thin films. The composition ratio (element ratio) of the alloy composition of palladium and cobalt in the targets used under conditions 1 to 14 was 50:50, and it is believed that the element ratio of the thin film was determined according to this ratio.

Further, tricobalt tetroxide tended to be detected in the thin films under all of conditions 1 to 13. Under condition 14, no tricobalt tetroxide was detected.

The thin film according to condition 8 was further subjected to a heat treatment. The heat treatment was carried out under the same atmosphere as the thin film deposition conditions under condition 8. That is, the pressure inside the chamber where the heat treatment was carried out was set to 0.20 Pa, and a mixed gas of argon (Ar) and oxygen (O₂) was supplied to the chamber. Of the mixed gas supplied, the flow rate of oxygen was 14 SCCM and the flow rate of argon was 4 SCCM. That is, the O₂/Ar ratio of the mixed gas was set to 3.5.

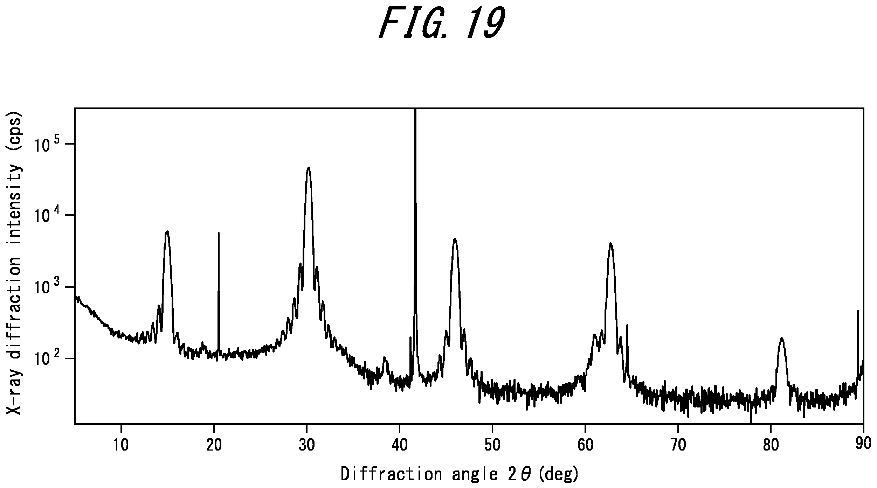

The thin film was heated together with the substrate on which it was formed. The substrate temperature was 750 °C, which was higher than the substrate temperature (700 °C) during film formation under condition 8. The heat treatment was carried out for 1 h. FIG. 19 illustrates the X-ray diffraction pattern of the thin film after this heat treatment.

From a comparison of the X-ray diffraction pattern of the thin film after the heat treatment illustrated in FIG. 19 with the X-ray diffraction pattern of the thin film under condition 8 (thin film before the heat treatment) illustrated in FIG. 12, a change in the peak intensity of palladium cobalt oxide before and after the heat treatment was not confirmed.

### (Production Example 4)

From the results of conditions 1 to 14, it was found that an O₂/Ar ratio of about 3.5 was often preferable. It was also suggested that the substrate temperature should preferably be lower than 750 °C. It was also found that when the pressure of the atmosphere during film formation was 0.20 Pa or less, the amount of cobalt oxide in the thin film was decreased, which is preferable.

Therefore, further, using the target of Production Example 1, thin films according to conditions 15 to 28 (see Table 2) and conditions 29 to 34 (see Table 3) were produced under the film formation conditions listed in Table 2 or Table 3, and evaluated. The other conditions were the same as those in Production Example 3. Tables 2 and 3 list the evaluation results of these thin films. When the substrate temperature was 730 °C, the temperature of the substrate heater in the sputtering device was 775 °C. Further, the thin film under condition 27 was obtained by subjecting the thin film under condition 26 to heat treatment (post-annealing) at 800 °C for 12 h. Similarly, the thin film under condition 31 was obtained by subjecting the thin film under condition 30 to heat treatment at 800 °C for 12 h.

**[Table 2]**

| | Target | Film formation conditions | | | | | | XRD evaluation | Film Thickness (nm) | Resistivity | | RRR |
|---|---|---|---|---|---|---|---|---|---|---|---|---|
| | | RF Output | Pressure | Oxygen | Argon | O₂/Ar ratio | Substrate temperature | PdCoO₂ detected | | 300 K (Ωcm) | 2 K (Ωcm) | |
| | | (W) | (Pa) | (sccm) | (sccm) | (-) | (°C) | | | | | |
| Condition 15 | Production Example 1 | 60 | 0.15 | 14 | 4 | 3.5 | 700 | yes | not rated | not rated | not rated | not rated |
| Condition 16 | Production Example 1 | 60 | 0.10 | 14 | 4 | 3.5 | 700 | yes | not rated | not rated | not rated | not rated |
| Condition 17 | Production Example 1 | 60 | 0.10 | 16 | 4 | 4.0 | 700 | yes | not rated | not rated | not rated | not rated |
| Condition 18 | Production Example 1 | 60 | 0.15 | 14 | 4 | 3.5 | 730 | yes | 11.4 | 8.17×10⁻⁶ | 3.87×10⁻⁶ | 2.11 |
| Condition 19 | Production Example 1 | 50 | 0.15 | 14 | 4 | 3.5 | 700 | yes | 7.7 | 1.19×10⁻⁴ | 9.87×10⁻⁵ | 1.20 |
| Condition 20 | Production Example 1 | 70 | 0.15 | 14 | 4 | 3.5 | 700 | yes | 16.1 | 9.32×10⁻⁶ | 4.59×10⁻⁶ | 2.03 |
| Condition 21 | Production Example 1 | 80 | 0.15 | 14 | 4 | 3.5 | 700 | yes | 20.3 | 6.94x10⁻⁶ | 2.94×10⁻⁶ | 2.36 |
| Condition 22 | Production Example 1 | 65 | 0.15 | 14 | 4 | 3.5 | 700 | yes | 13.15 | 9.78×10⁻⁶ | 5.11×10⁻⁶ | 1.91 |
| Condition 23 | Production Example 1 | 75 | 0.15 | 14 | 4 | 3.5 | 700 | yes | 17.99 | 7.78×10⁻⁶ | 3.63×10⁻⁶ | 2.17 |
| Condition 24 | Production Example 1 | 100 | 0.15 | 14 | 4 | 3.5 | 700 | yes | 34.2 | 5.78×10⁻⁶ | 2.29×10⁻⁶ | 2.52 |
| Condition 25 | Production Example 1 | 120 | 0.15 | 14 | 4 | 3.5 | 700 | yes | 48.08 | 6.77×10⁻⁶ | 2.63×10⁻⁶ | 2.57 |
| Condition 26 | Production Example 1 | 100 | 0.15 | 14 | 4 | 3.5 | 700 | yes | 162.32 | 4.66×10⁻⁶ | 1.45×10⁻⁶ | 3.21 |
| Condition 27 | Production Example 1 | thin film under condition 26 heat treated at 800 °C for 12 h | | | | | | | 161.32 | 3.49×10⁻⁶ | 4.57×10⁻⁷ | 7.63 |
| Condition 28 | Production Example 1 | 140 | 0.15 | 14 | 4 | 3.5 | 700 | yes | 61.47 | 5.07×10⁻⁶ | 1.79×10⁻⁶ | 2.83 |

**[Table 3]**

| | Target | Film formation conditions | | | | | | XRD evaluation | Film Thickness (nm) | Resistivity | | RRR |
|---|---|---|---|---|---|---|---|---|---|---|---|---|
| | | RF Output | Pressure | Oxygen | Argon | O₂/Ar ratio | Substrate temperature | PdCoO₂ detected | | 300 K (Ωcm) | 2 K (Ωcm) | |
| | | (W) | (Pa) | (sccm) | (sccm) | (- ) | (°C) | | | | | |
| Condition 29 | Production Example 1 | 100 | 0.10 | 14 | 4 | 3.5 | 700 | yes | 27.0 | not rated | not rated | not rated |
| Condition 30 | Production Example 1 | 100 | 0.20 | 14 | 4 | 3.5 | 700 | not rated | not rated | not rated | not rated | not rated |
| Condition 31 | Production Example 1 | thin film under condition 30 heat treated at 800 °C for 12 h | | | | | | | 27.8 | 4.07×10⁻⁶ | 5.18×10⁻⁷ | 7.9 |
| Condition 32 | Production Example 1 | 100 | 0.50 | 14 | 4 | 3.5 | 700 | yes | 27.6 | not rated | not rated | not rated |
| Condition 33 | Production Example 1 | 100 | 3 | 14 | 4 | 3.5 | 700 | yes | 13.2 | not rated | not rated | not rated |
| Condition 34 | Production Example 1 | 100 | 20 | 14 | 4 | 3.5 | 700 | yes | not rated | not rated | not rated | not rated |

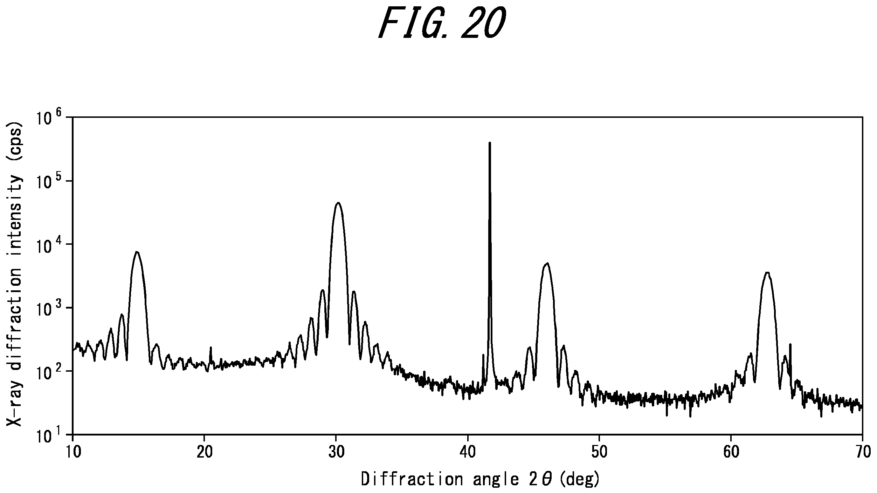

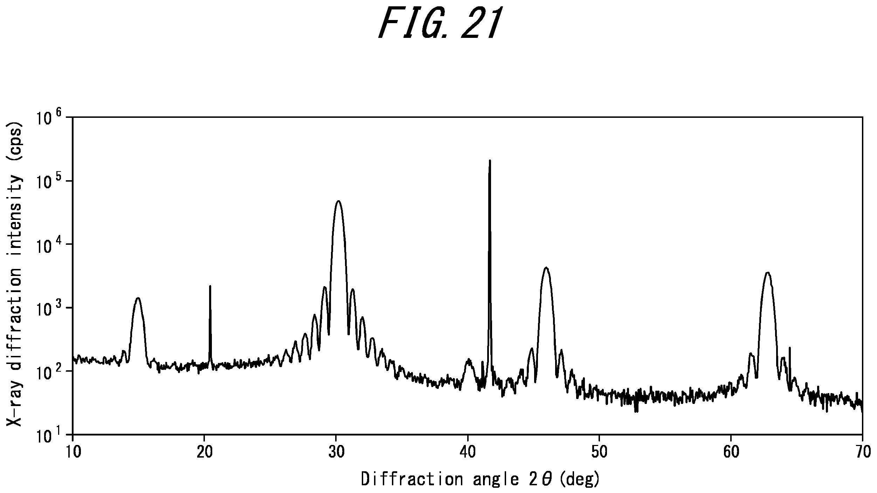

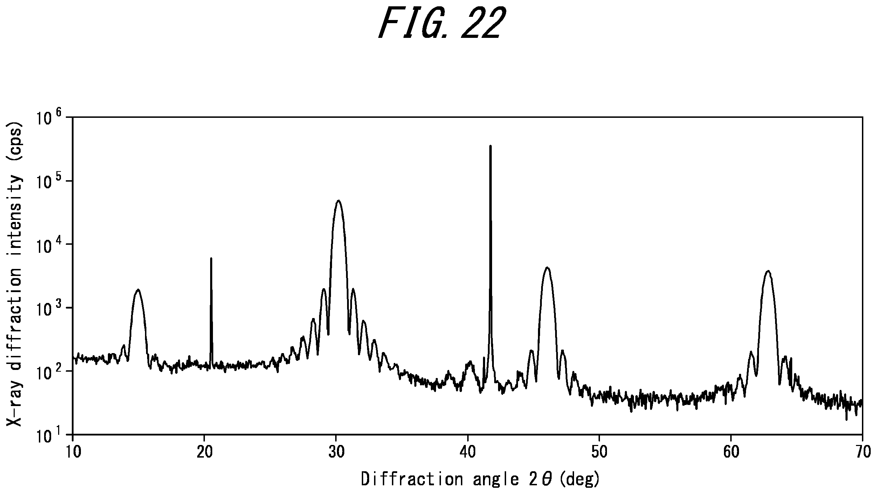

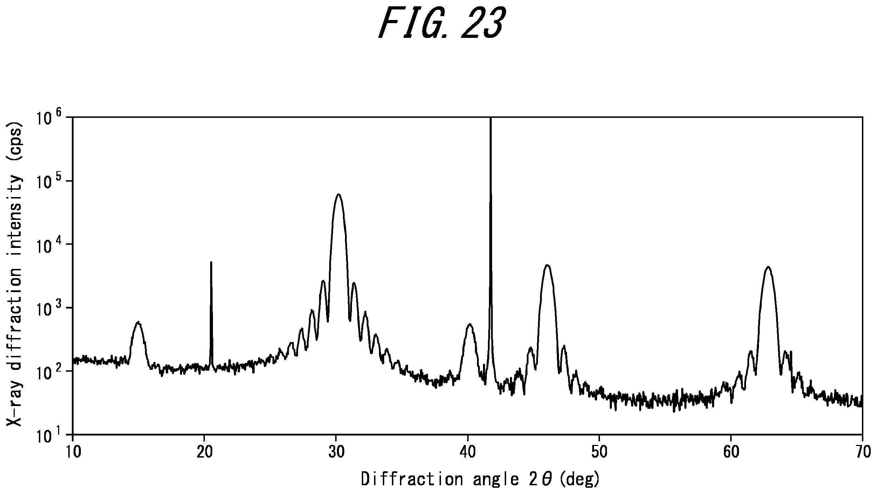

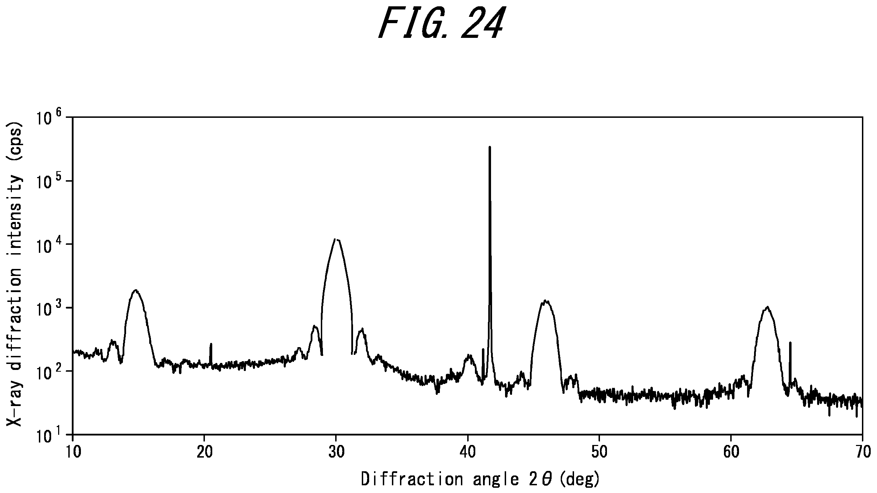

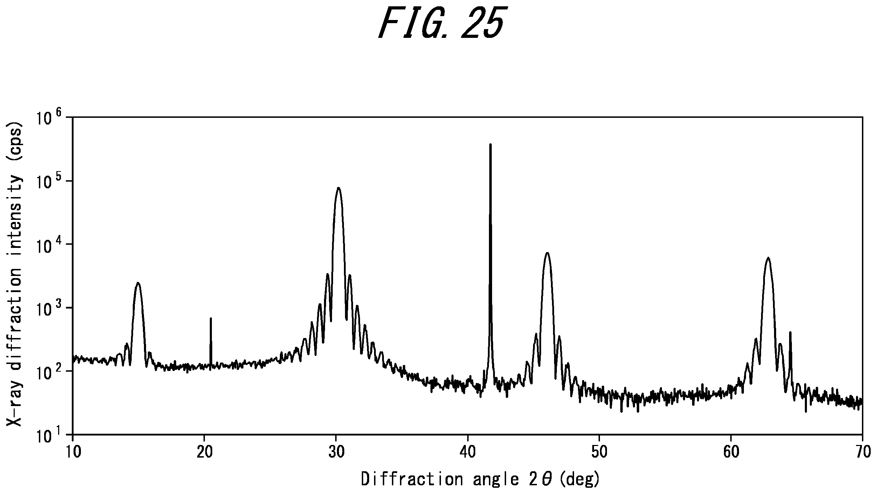

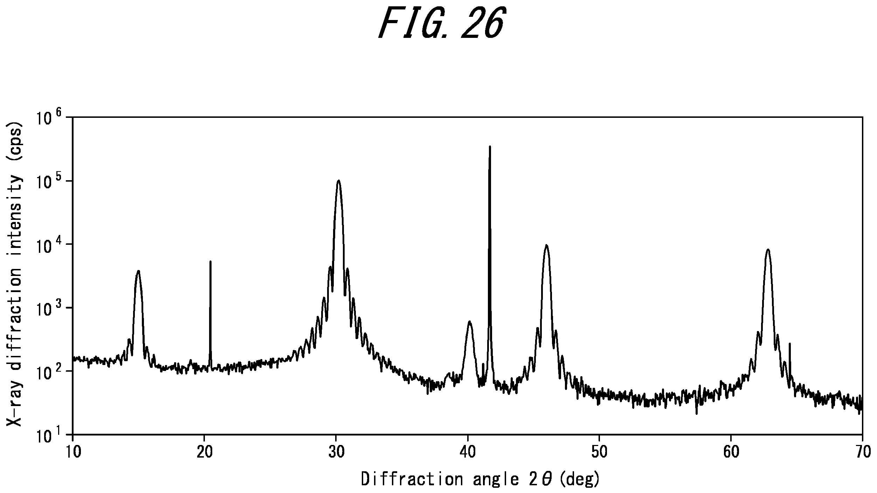

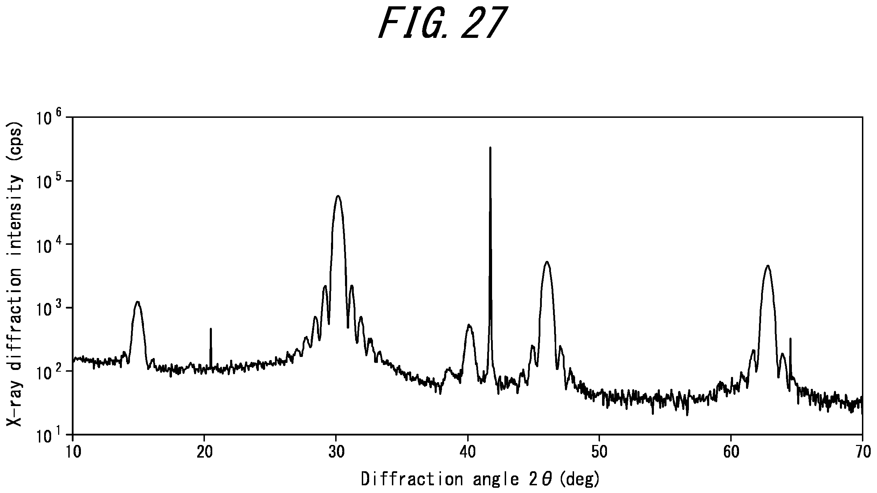

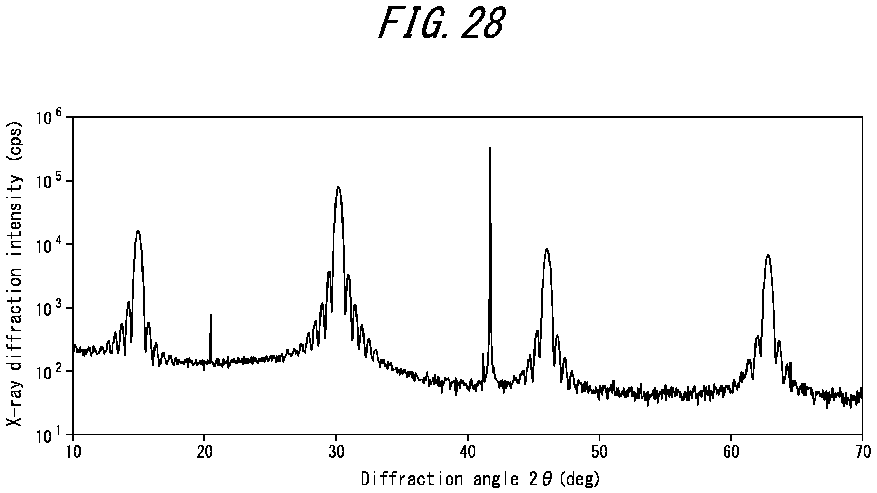

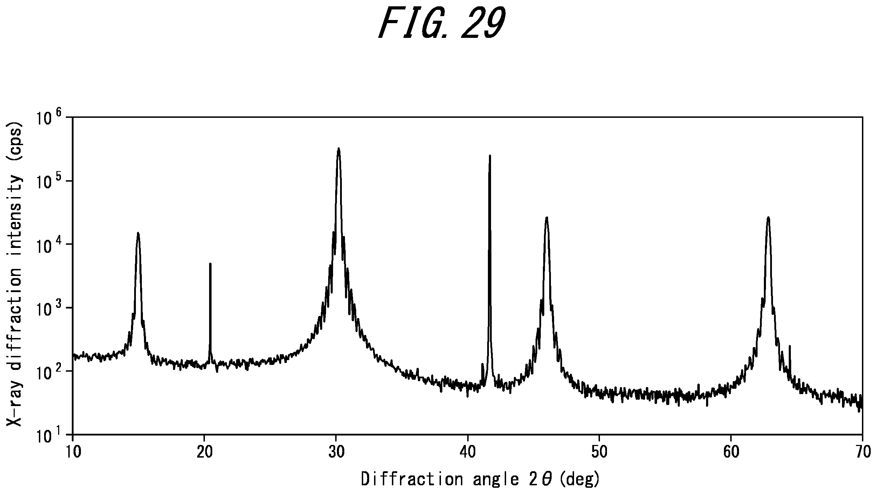

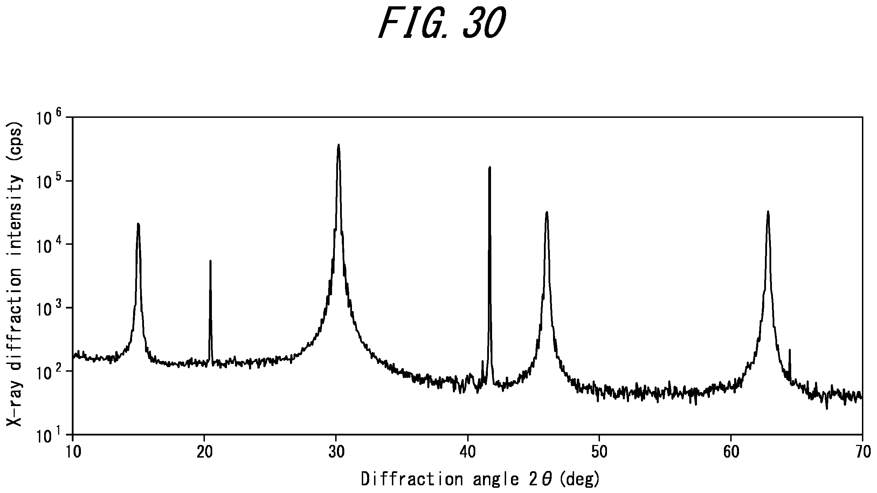

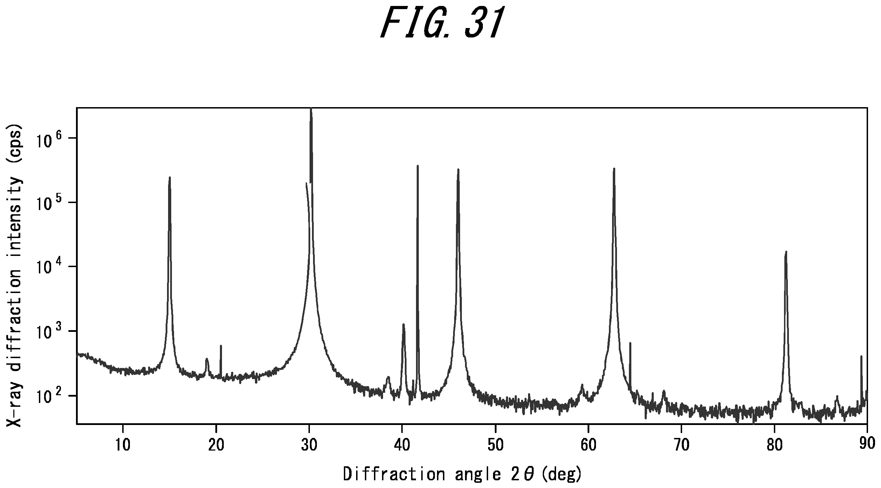

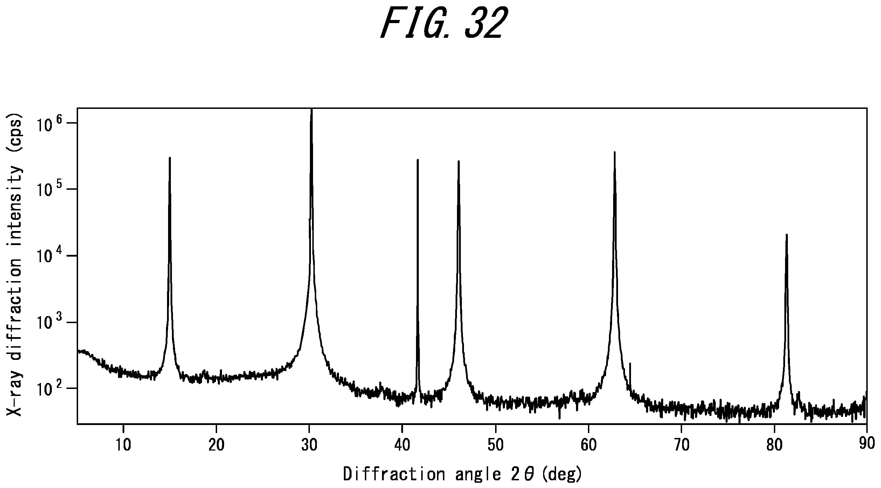

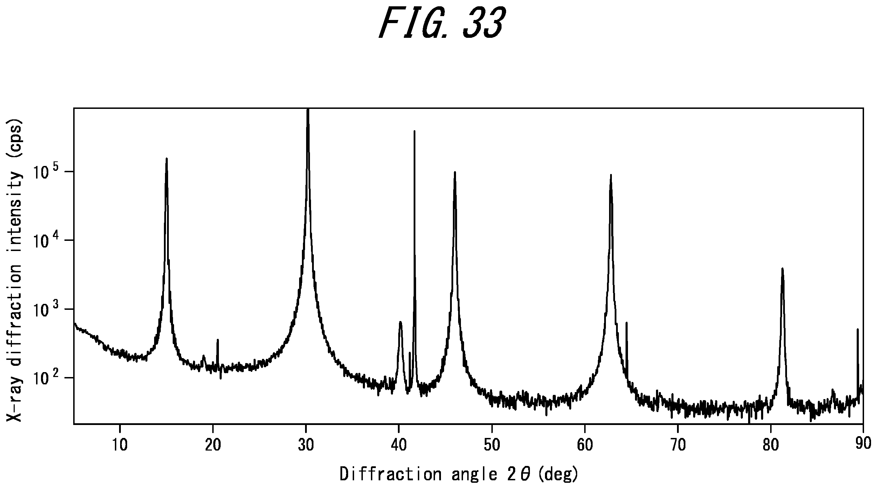

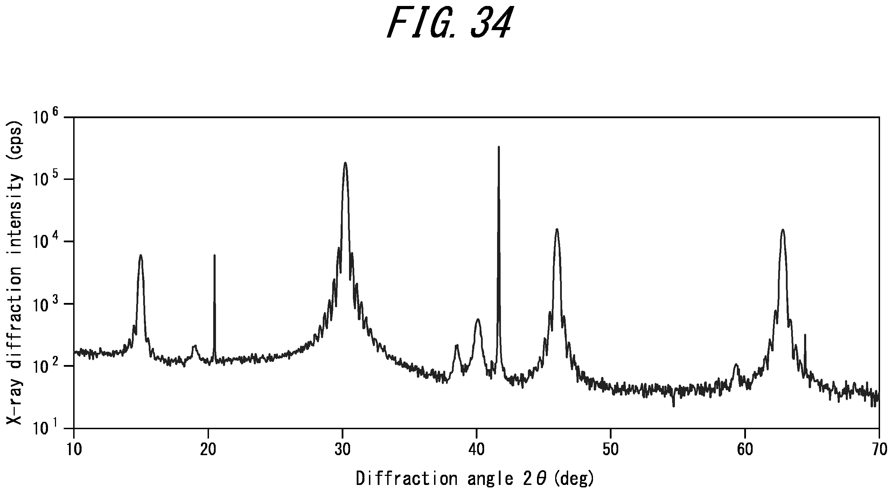

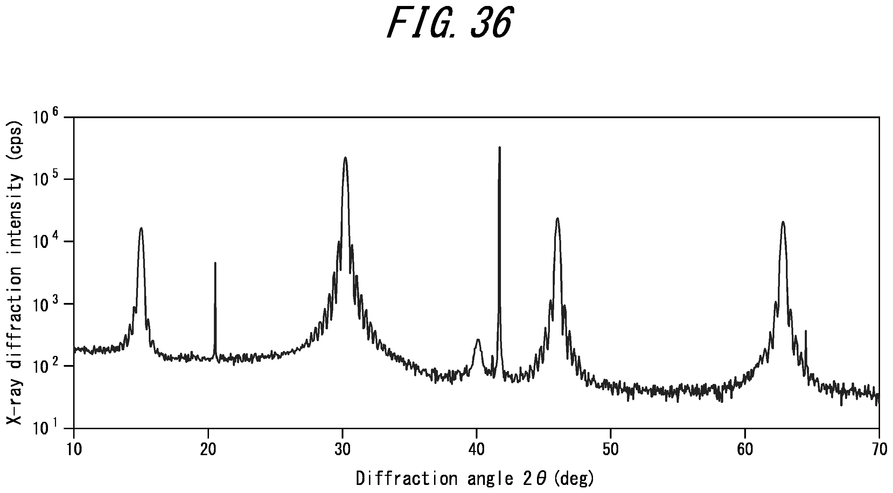

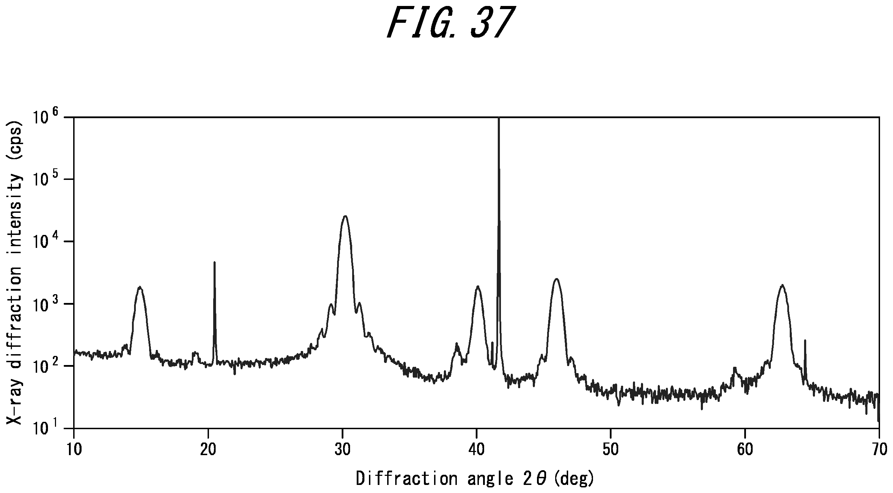

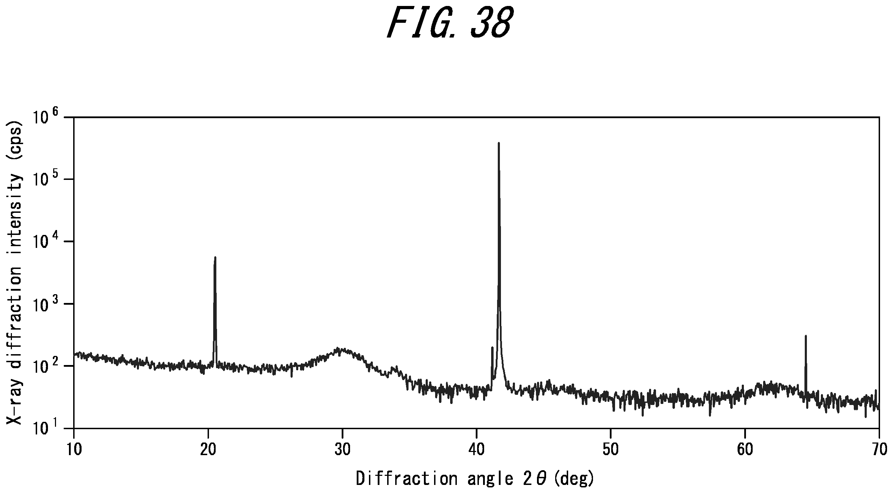

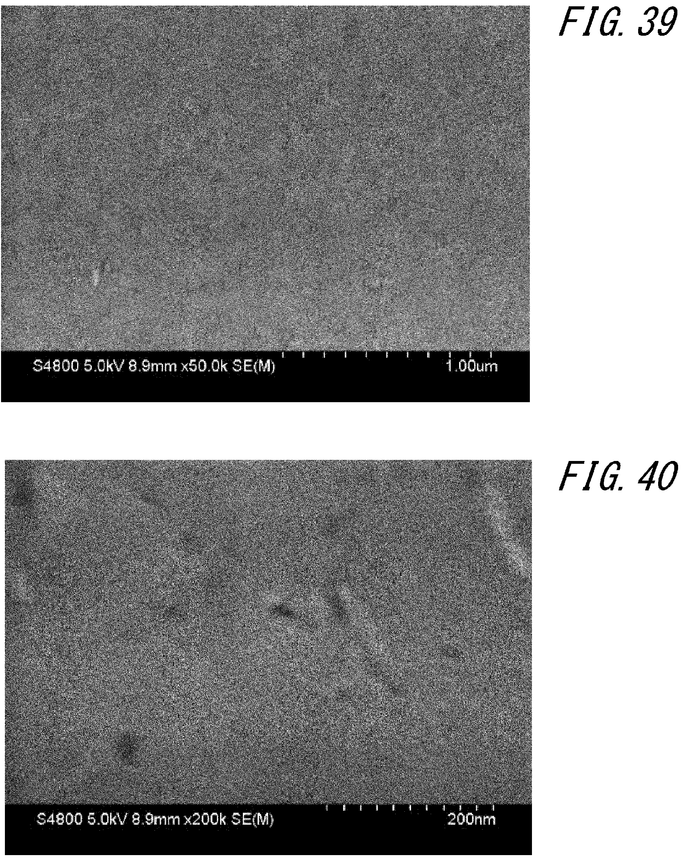

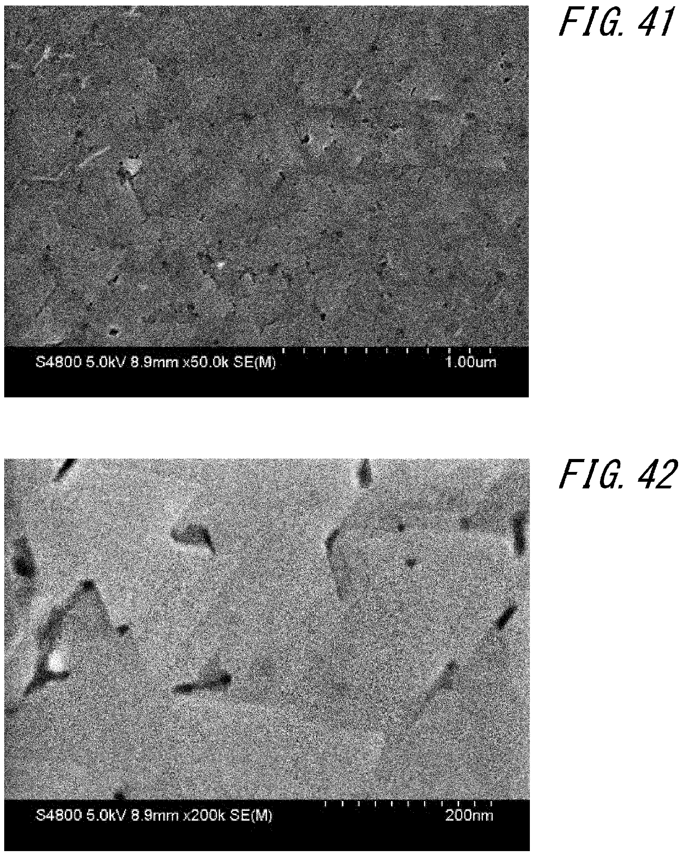

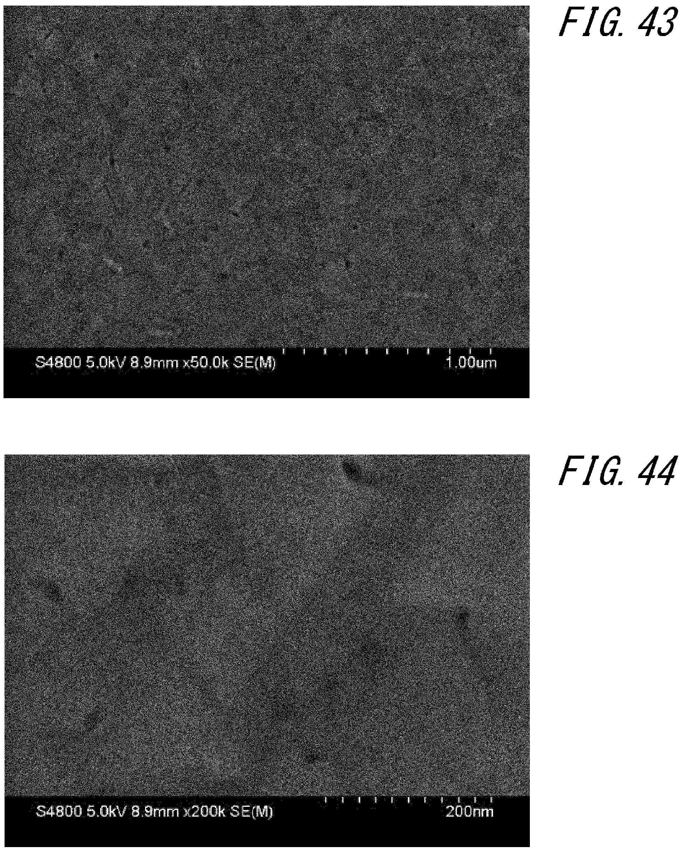

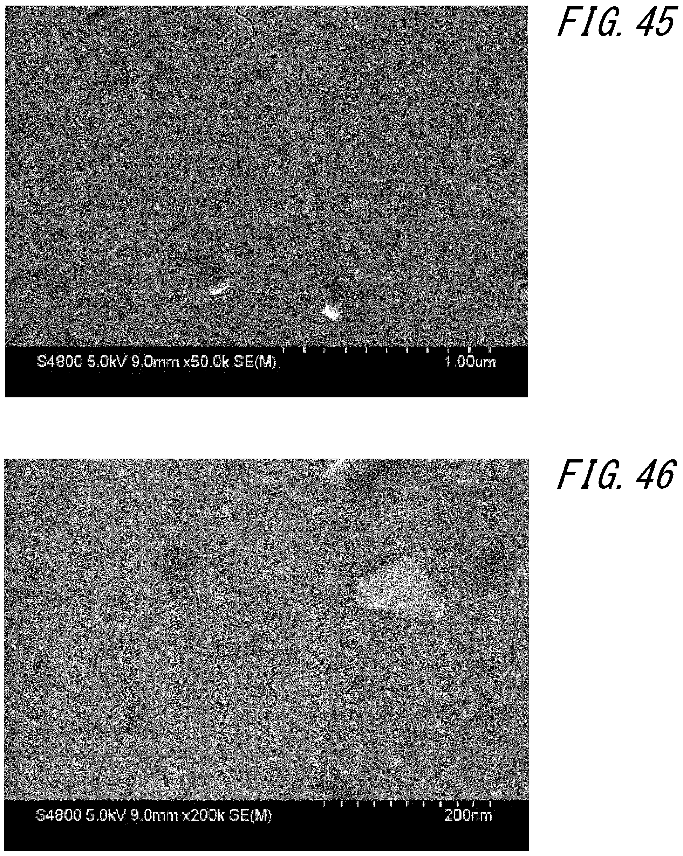

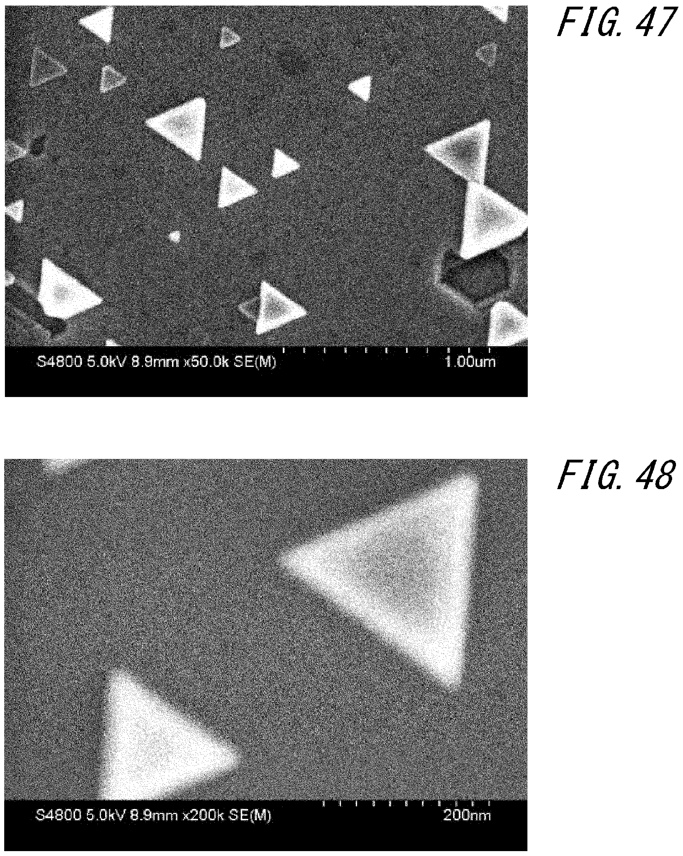

FIG. 20 to FIG. 33 illustrate the X-ray diffraction patterns of the thin films according to conditions 15 to 28, in this order. FIG. 34 to FIG. 38 illustrate the X-ray diffraction patterns of the thin films according to condition 29, and conditions 31 to 34, in this order. FIG. 39 to FIG. 48 illustrate SEM images of the thin films according to conditions 23 to 27. The SEM images were taken by the above-mentioned SEM-EDX. Further, when the element ratio of palladium to cobalt in the thin films under conditions 15 to 28 was measured using an ICP optical emission spectrometer, the Pd:Co ratio was in the range of 48.8:51.2 to 49.0:51.0 for all of the thin films, as in the cases of conditions 1 to 14.

For the thin films under conditions 18 to 29 and conditions 31 to 33, the film thickness (nm) was determined in the same way as in Production Example 3. The thicknesses of these thin films are also listed in Tables 2 and 3. The thin films produced under conditions 18 to 28, 29, and 31 to 33 each have a film thickness of approximately 7.0 nm or more and 165.0 nm or less.

The electrical resistivity (Ωcm) at a temperature of 300 K and the electrical resistivity (Ωcm) at a temperature of 2 K of the thin films under conditions 18 to 28 and 31 were measured in the same way as in Production Example 3. Further, the RRR was determined in the same way as in Production Example 3. The electrical resistivity and RRR values of these thin films are listed in Tables 2 and 3.

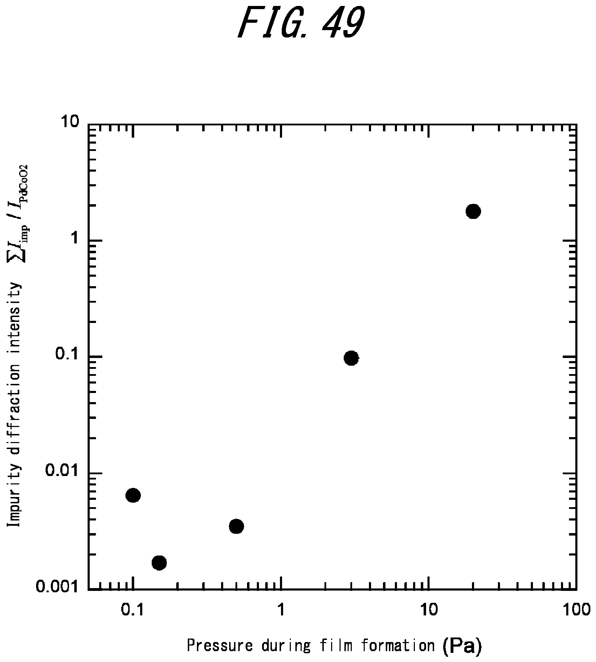

As indicated in Tables 2 and 3, for this Production Example, palladium cobalt oxide (PdCoO₂) having a delafossite-type crystal structure was detected under all conditions, confirming that it was possible to form a thin film containing palladium cobalt oxide under these conditions. FIG. 49 illustrates a graph obtained by investigating the relationship between the pressure during film formation and the peak intensity ratio in X-ray diffraction under conditions 24, 29, and 32 to 34. The peak intensity ratio in X-ray diffraction was determined as the ratio of the sum of X-ray diffraction peak intensities of impurity Σ*I*ᵢₘₚ to the intensity of the PdCoO₂ (006) peak *I*_{PdCoO2}. As illustrated in FIG. 49, when the pressure during film formation was 0.5 Pa or less, the sum of the X-ray diffraction peak intensities of impurity, Σ*I*ᵢₘₚ, was controlled to less than 1 % of the intensity *I*_{PdCoO2} of the PdCoO₂ (006) peak, and a high-quality PdCoO₂ thin film was obtained.

As described above, the larger the RRR value, the lower the crystal defect density, which is preferable for an electrode. In this Production Example, the thin films under the conditions for which RRR was evaluated (conditions 18 to 28 and condition 31) all had an RRR of 1 or more, which was favorable.

Further, for the thin films under the conditions under which the RRR was evaluated in this Production Example (conditions 18 to 28 and 31), the RRR was 1 or more even when the film thickness was, for example, 20 nm or more, 30 nm or more, or even 100 nm or more, and therefore it can be determined that the thin films can be suitably used in various devices. For example, the thin film may be considered to be extremely suitable for use as a Schottky electrode in combination with gallium oxide or the like.

It can be seen that a higher (larger) RRR can be achieved by post-annealing the thin film (see condition 27). For the thin film under condition 27 obtained by post-annealing the thin film under condition 26, the RRR approached 8, reaching 7.63. Further, under condition 31, the RRR was even higher, reaching 7.9, even though the film thickness was less than 30 nm. When the thin film used according to the present embodiment is used as a Schottky electrode or wiring, it is particularly preferable that the film thickness is less than 30 nm and that the RRR is high. The thin film satisfying condition 31 satisfied these requirements, and can be said to have extremely favorable characteristics as a Schottky electrode or wiring.

Here, the RRR of a metallic conductive delafossite-type oxide thin film produced using a target of conventional technology is 1 or more and less than 3.

In contrast, under conditions 26, 27, and 31, an RRR of 3.0 or more and 8.0 or less can be achieved. From the above results, it is clear that according to the present embodiment, it is possible to form a delafossite-type oxide thin film with extremely low resistance, which has not been possible conventionally.

Information on the RRR of metallic conductive delafossite-type oxide thin films prepared using targets according to conventional technology is described in, for example, the following Literature 1 to 5.
Literature 1: T. Harada et al., APL Materials 6, 046107 (2018)
Literature 2: P. Yordanov et al., Physical Review Materials 3, 085403 (2019)
Literature 3: J.M. Ok et al., APL Materials 8, 051104 (2020)
Literature 4: T. Miyakawa et al., Journal of Applied Physics 128, 025302 (2020)
Literature 5: T. Harada et al., Journal of Applied Physics 133, 085302 (2023)

In addition, as illustrated in FIG. 39 to FIG. 48, well-defined triangular crystal structures characteristic of delafossite-type oxides were observed in each thin film.

### (Production Example 5)

The target according to Production Example 5 was produced as follows.

An alloy powder produced by gas atomization (produced by Tanaka Kikinzoku Kogyo K.K.), which had a composition ratio (element ratio) of platinum and cobalt of 50:50 (platinum and cobalt content of approximately 50 at% each), with the balance being impurity, was filled into a mold as the powder for sintering, followed by hot-press sintering at 1250 °C, in which pressure was applied in the thickness direction. The alloy powder was prepared by weighing platinum and cobalt (both metals) so that the composition ratio (element ratio) of the alloy composition was 50:50, heating the mixture to form a molten alloy, and then gas atomizing the molten alloy to obtain atomized powder.

The composition ratio of platinum to cobalt in the obtained sintered product was 50.02:49.98 (the content of platinum and cobalt was 50.02 at% and 49.98 at%, respectively). Twenty elements considered to be impurity were detected in the sintered product, and the impurity concentration in the sintered product was 211 ppm. The purity of the platinum and cobalt alloy was 99.97 wt%. The sintered product was then processed to obtain a disk-shaped target as the target according to this Production Example. The surfaces and side surface of the disk of the target were ground to prepare for subsequent use. The target after shape adjustment was a disk having a diameter of 50.8 mm and a thickness t of about 1.0 mm.

### (Production Example 6)

Using the target of Production Example 5, a thin film of platinum cobalt oxide (PtCoO₂) was formed by reactive sputtering. The thin film in Production Example 6 was formed by changing the target and film formation conditions as follows.

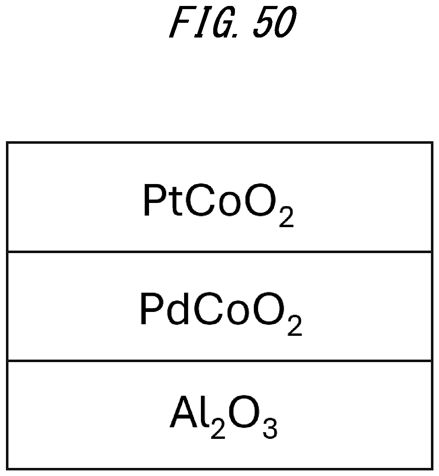

An Al₂O₃ (sapphire) substrate (0001) was used as the substrate for forming the thin films. The substrate used had been annealed at 1100 °C for 2 h. FIG. 50 illustrates a schematic cross-section diagram of a substrate on which a thin film of platinum cobalt oxide is formed. In Production Example 6, as illustrated in FIG. 50, a thin film of palladium cobalt oxide (PdCoO₂) was formed on a substrate in the same way as in Production Example 3 to a thickness of 13.8 nm, and then a thin film of platinum cobalt oxide was formed on the palladium cobalt oxide film.

The sputtering was carried out using a sputtering device (model: ESCS-232S) produced by Eiko Engineering Ltd. RF or DC electrical power was applied between the target and the substrate. The RF output was 60 W, 100 W, or 140 W, and the frequency was 13.56 MHz. The DC output was 60 W.

The pressure in the chamber where the film was formed was 0.15 Pa, 0.30 Pa, 1 Pa, or 5 Pa. The TS distance was 150 mm.

The reactive gas supplied to the chamber for reactive sputtering was a mixed gas of argon (Ar) and oxygen (O₂). The flow rates of the reactive gases in the chamber were 4 sccm for argon and 14 sccm or 28 sccm for oxygen. The O₂/Ar ratio was 3.5 or 7.0.

The substrate temperature during film formation was 700 °C or 750 °C. The temperature control of the substrate was carried out by setting the temperature of the substrate heater in the sputtering device to 750 °C or 800 °C, respectively.

The film formation conditions were changed as described above, and nine types of platinum cobalt oxide thin films under conditions 35 to 42 were produced. Table 4 lists the film formation conditions from condition 35 to condition 42. Further, Table 5 lists the evaluation results (described later) for conditions 35 to 42.

**[Table 4]**

| | PtCoO₂ target | PtCoO₂ layer deposition conditions | | | | | |
|---|---|---|---|---|---|---|---|
| | | Sputtering power supply/output | Pressure | Oxygen | Argon | O₂/Ar ratio | Substrate temperature |
| | | (W) | (Pa) | (sccm) | (sccm) | (-) | (°C) |
| Condition 35 | Production Example 5 | RF / 100 | 0.15 | 14 | 4 | 3.5 | 700 |
| Condition 36 | Production Example 5 | RF / 140 | 0.3 | 14 | 4 | 3.5 | 750 |
| Condition 37 | Production Example 5 | RF / 60 | 1 | 14 | 4 | 3.5 | 750 |
| Condition 38 | Production Example 5 | RF / 60 | 0.15 | 14 | 4 | 3.5 | 750 |
| Condition 39 | Production Example 5 | RF / 60 | 1 | 28 | 4 | 7.0 | 750 |
| Condition 40 | Production Example 5 | RF / 100 | 5 | 28 | 4 | 7.0 | 700 |
| Condition 41 | Production Example 5 | thin film under condition 40 heat treated at 700 °C for 12 h | | | | | |
| Condition 42 | Production Example 5 | DC / 60 | 5 | 28 | 4 | 7.0 | 700 |
| Condition 43 | Production Example 5 | DC / 60 | 5 | 28 | 4 | 7.0 | 700 |
| Condition 44 (PdCoO₂ only) | - | - | - | - | - | - | - |

**[Table 5]**

| | PtCoO₂ target | XRD evaluation | | Resistivity of PtCoO₂/PdCoO₂ stacked structure | | RRR of PtCoO₂/PdCoO₂ stacked structure | Resistivity of PtCoO₂ layer | | RRR of PtCoO₂ layer |
|---|---|---|---|---|---|---|---|---|---|
| | | PdCoO₂ film thickness | PtCoO₂ film thickness | 300 K (Qcm) | 2 K (Qcm) | | 300 K (Qcm) | 2 K (Qcm) | |
| | | (nm) | (nm) | | | | | | |
| Condition 35 | Production Example 5 | 13.8 | 2.6 | not rated | not rated | not rated | not rated | not rated | not rated |
| Condition 36 | Production Example 5 | 13.8 | 4.3 | not rated | not rated | not rated | not rated | not rated | not rated |
| Condition 37 | Production Example 5 | 13.8 | 9.6 | 8.00×10⁻⁶ | 1.99×10⁻⁶ | 4.0 | 1.47×10⁻⁵ | 4.93×10⁻⁶ | 3.0 |
| Condition 38 | Production Example 5 | 13.8 | 6.8 | not rated | not rated | not rated | not rated | not rated | not rated |
| Condition 39 | Production Example 5 | 13.8 | 7.9 | 6.91×10⁻⁶ | 1.53×10⁻⁶ | 4.5 | 9.08×10⁻⁶ | 1.82×10⁻⁶ | 5.0 |
| Condition 40 | Production Example 5 | 13.8 | 5.6 | not rated | not rated | not rated | not rated | not rated | not rated |
| Condition 41 | Production Example 5 | 13.8 | 5.6 | 6.90×10⁻⁶ | 1.77×10⁻⁶ | 4.5 | 1.03×10⁻⁵ | 4.92×10⁻⁶ | 2.1 |
| Condition 42 | Production Example 5 | 13.8 | 3.3 | not rated | not rated | not rated | not rated | not rated | not rated |
| Condition 43 | Production Example 5 | 0.0 | peak present, film thickness unknown | not rated | not rated | not rated | not rated | not rated | not rated |
| Condition 44 (PdCoO₂ only) | - | 13.8 | 0.0 | 6.08×10⁻⁶ | 1.41×10⁻⁶ | 4.0 | - | - | - |

In Production Example 6, in order to compare with the platinum cobalt oxide thin films under conditions 35 to 42, films were formed under conditions 43 and 44, which are described later. Table 4 also lists the film formation conditions for condition 43. Table 5 also lists the evaluation results for conditions 43 and 44.

Under condition 43, a thin film of platinum cobalt oxide was formed directly on the Al₂O₃ substrate without forming a thin film of palladium cobalt oxide.

Further, under condition 44, a thin film of platinum cobalt oxide was not formed, and only a thin film of palladium cobalt oxide was formed on the Al₂O₃ substrate. Under conditions 37 to 42, platinum cobalt oxide was deposited on this palladium cobalt oxide thin film (a platinum cobalt oxide thin film was formed). The row for condition 44 in Table 5 lists the electrical resistivity and RRR values for the palladium cobalt oxide thin film alone.

For the thin films under conditions 35 to 42, the film thickness (nm) was determined in the same way as in Production Example 3. The thicknesses of these thin films are also listed in Table 5. The platinum cobalt oxide thin films produced under conditions 35 to 42 had a film thickness of approximately 2.6 nm or more and 9.6 nm or less.

The electrical resistivity (Ωcm) at a temperature of 300 K and the electrical resistivity (Ωcm) at 2 K of the entire stacked film of palladium cobalt oxide and platinum cobalt oxide under conditions 37, 39, and 41 were measured in the same way as in Production Example 3. Then, in the same way as in Production Example 3, the RRR of the entire stacked film was determined.

The electrical resistivity (Ωcm) at a temperature of 300 K and the electrical resistivity (Ωcm) at 2 K of the palladium cobalt oxide alone under conditions 37, 39, and 41 were the values listed under condition 44 in Table 5.

The sheet resistance Rₜₒₜₐₗ (Ω/sq) of the entire stacked film is given by 1/Rₜₒₜₐₗ = 1/R_{PdCoO2} + 1/R_{PtCoO2}, where R_{PdCoO2} is the sheet resistance of palladium cobalt oxide and R_{PtCoO2} is the sheet resistance of platinum cobalt oxide. The thin film under each condition was measured to determine Rₜₒₜₐₗ, and the thin film under condition 44 was measured to determine R_{PdCoO2}. By substituting these values into the above equation, R_{PtCoO2} was calculated.

The electrical resistivity ρ_{PtCoO2} (Ωcm) of platinum cobalt oxide can be calculated using the film thickness d_{PtCoO2} (cm) of platinum cobalt oxide as follows: ρ_{PtCoO2} = R_{PtCoO2} × d_{PtCoO2}. The thickness of the entire delafossite phase was determined from the period of the fringes near the delafossite phase (0006) peak in the X-ray diffraction, and d_{PtCoO2} was determined by subtracting the thickness of the palladium cobalt oxide from the determined thickness. By this procedure, ρ_{PtCoO2} at 300 K and 2 K was determined, and by taking the ratio thereof, the RRR of the palladium cobalt oxide alone under conditions 37, 39, and 41 was calculated. The electrical resistivity and RRR of these thin films are also listed in Table 5.

As indicated in Table 5, under conditions 37, 39, and 41, the RRR was 1 or more, ranging from 2.1 to 5.0. In particular, under conditions 37 and 39, extremely high RRR values of 3.0 to 5.0 were obtained. When the RRR is 1 or more, the thin film can be judged to be suitably usable for various devices. For example, the thin film may be considered to be extremely suitable for use as a Schottky electrode in combination with gallium oxide or the like.

It can be seen that the thin film can achieve good RRR even by post-annealing (see condition 41). The thin film under condition 41, which is obtained by post-annealing the thin film under condition 40, has a good RRR of 2.1.

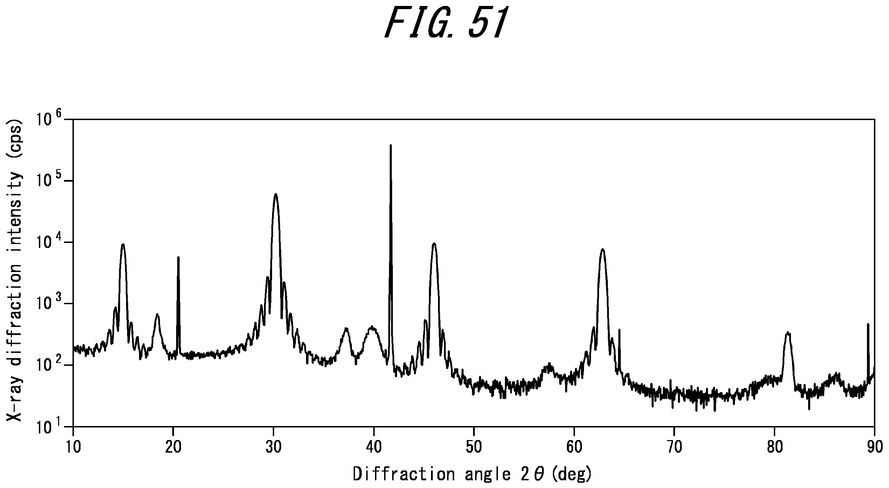

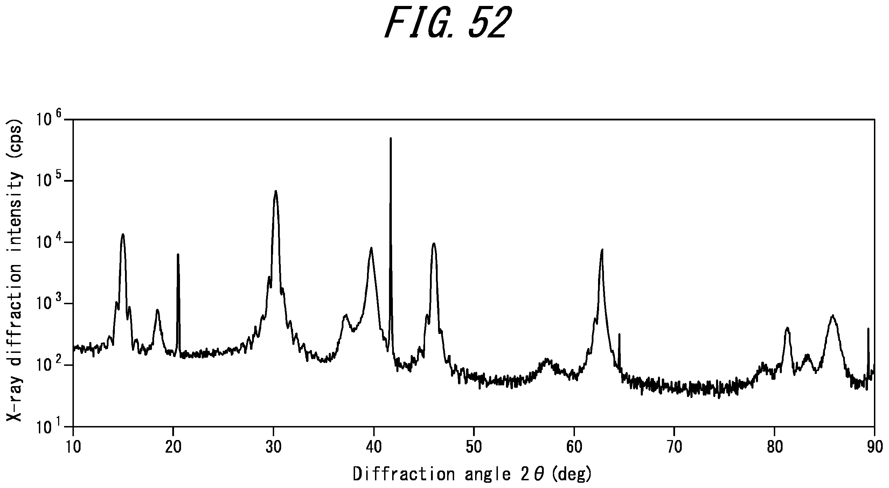

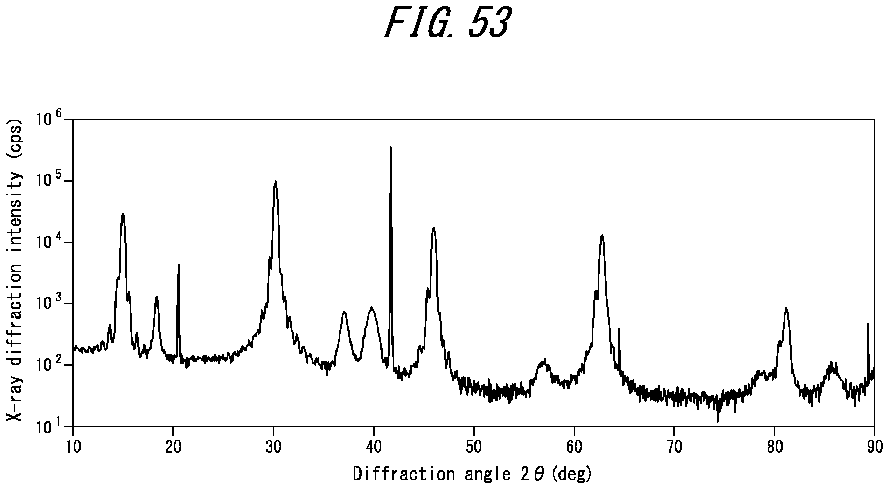

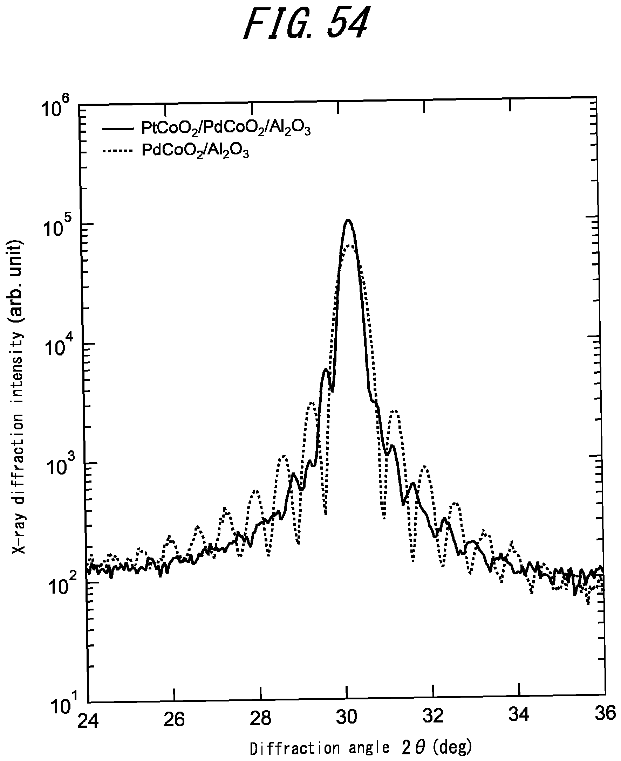

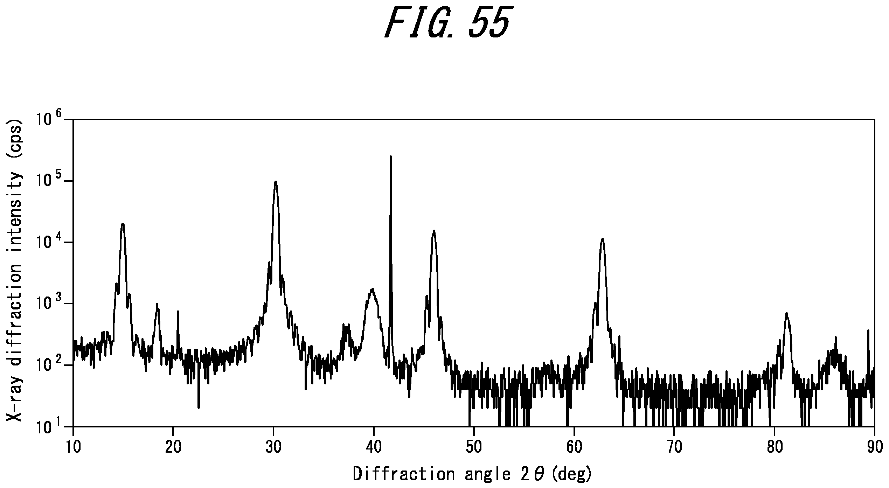

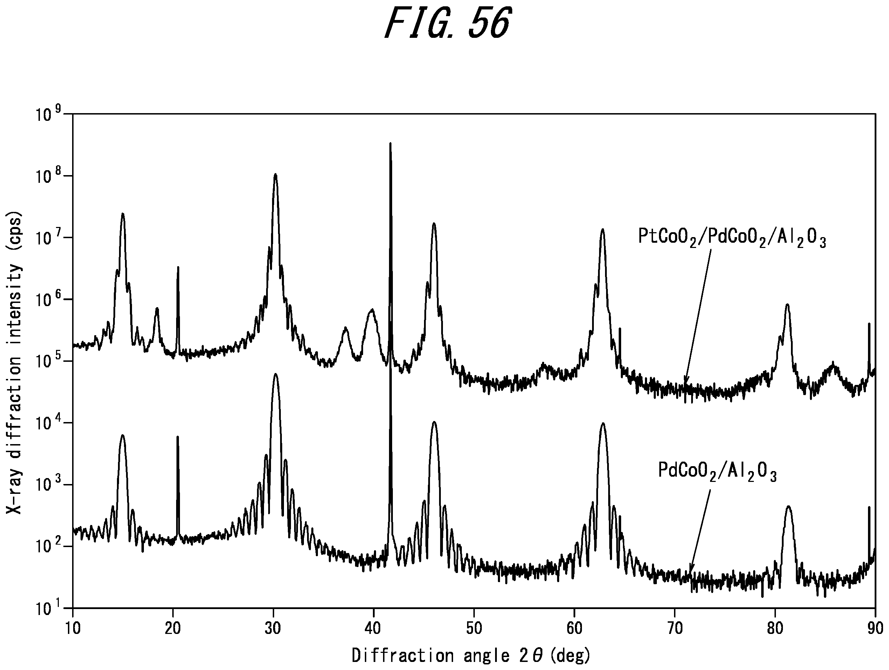

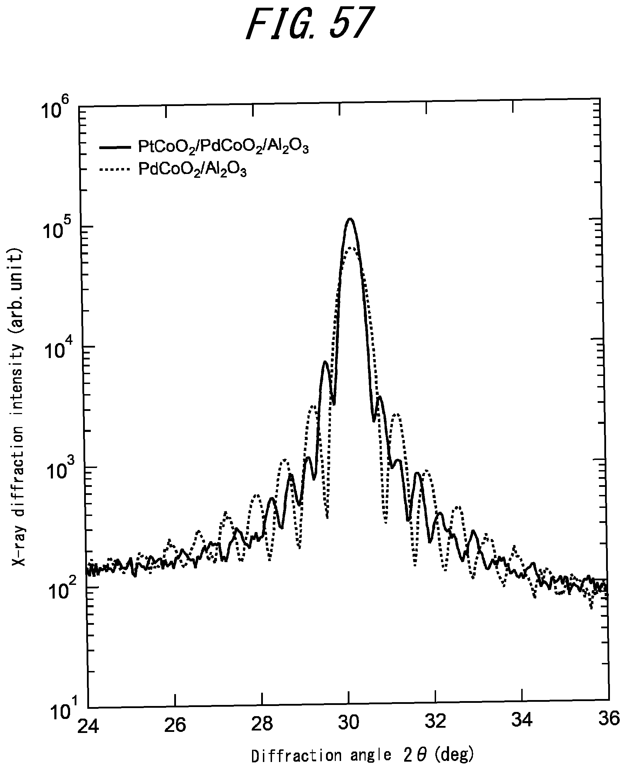

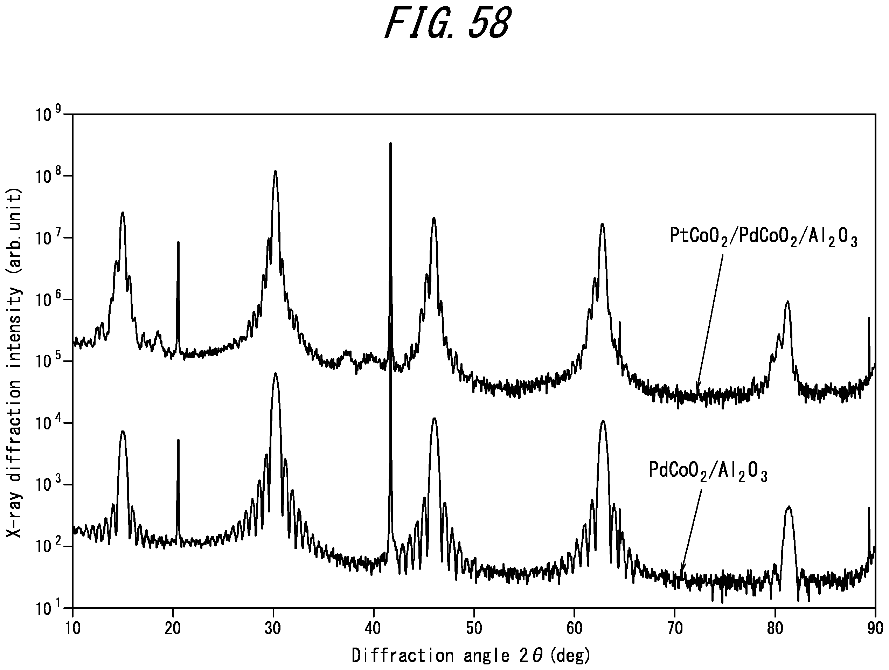

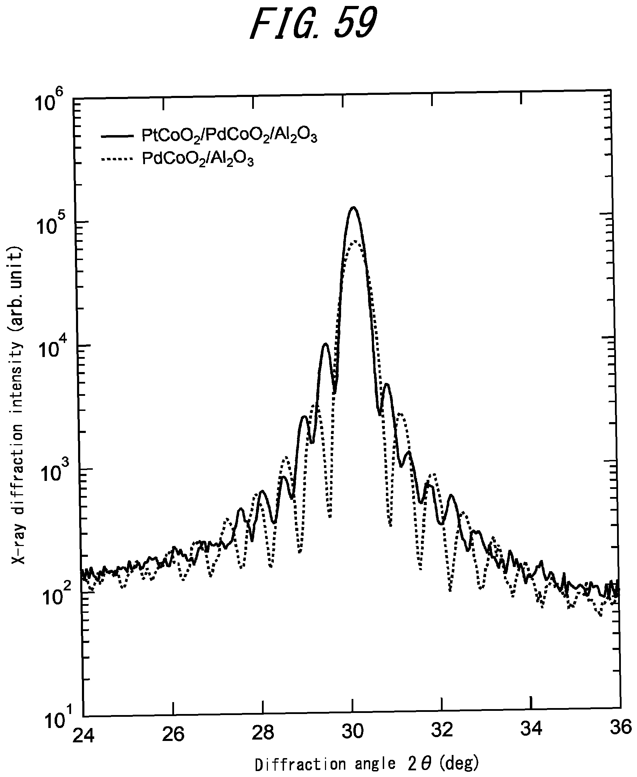

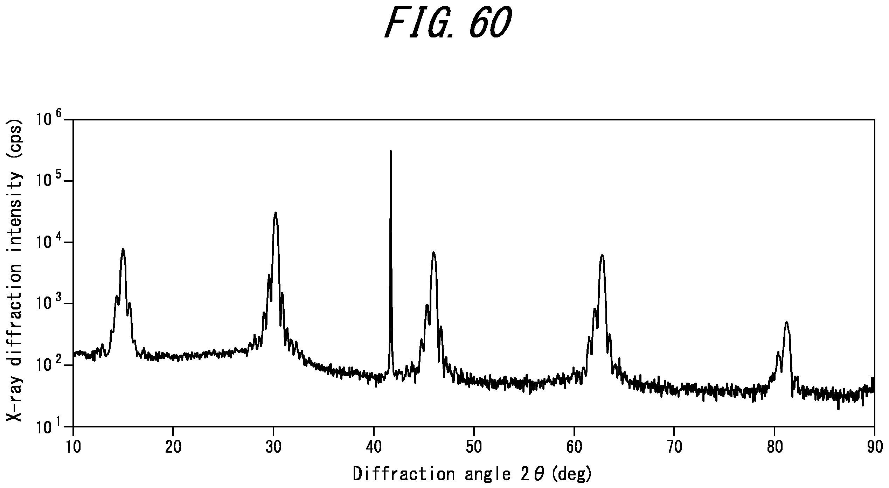

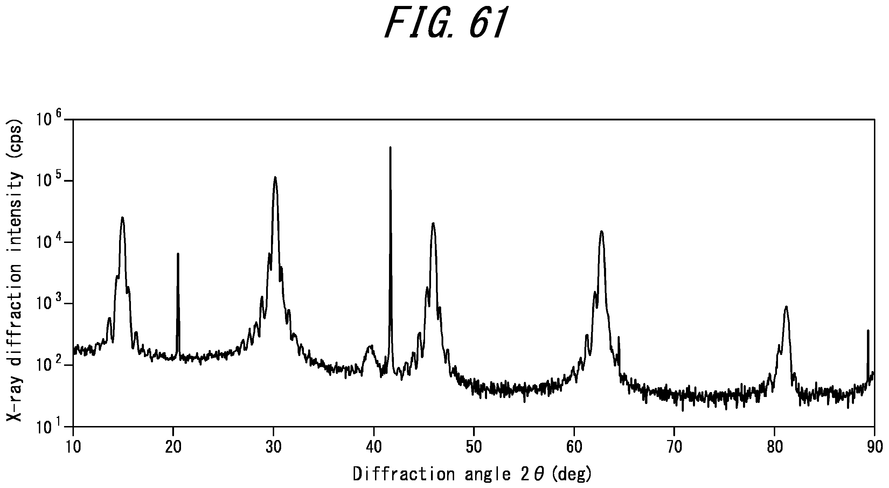

FIG. 51 to FIG. 53 illustrate the X-ray diffraction patterns of the thin films according to conditions 35 to 37, in this order. FIG. 54 illustrates an enlarged view of the X-ray diffraction pattern of the thin film according to condition 37. FIG. 55 illustrates the X-ray diffraction pattern of the thin film according to condition 38. FIG. 56 illustrates the X-ray diffraction patterns of the thin films according to the conditions 39 and 44. FIG. 57 illustrates an enlarged view of the X-ray diffraction pattern of the thin film according to condition 39. FIG. 58 illustrates the X-ray diffraction patterns of the thin films according to conditions 40 and 44. FIG. 59 illustrates an enlarged view of the X-ray diffraction pattern of the thin film according to condition 40. FIG. 60 to FIG. 62 illustrate the X-ray diffraction patterns of the thin films according to conditions 41 to 43.

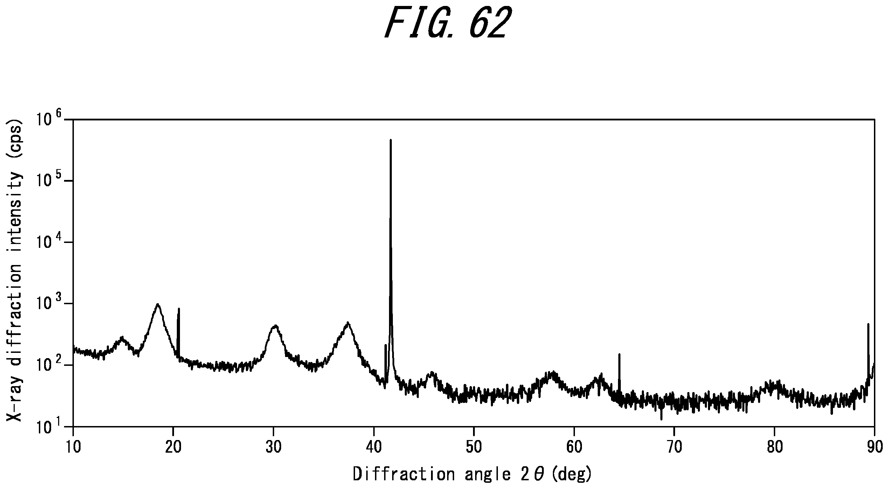

As illustrated in FIG. 51 to FIG. 61 , it was found that by using a thin film of palladium cobalt oxide (a first layer having a delafossite-type crystal structure) as a base, it is possible to deposit a platinum cobalt oxide having a delafossite-type crystal structure with good RRR, that is, to form a thin film of platinum cobalt oxide (a second layer having a delafossite-type crystal structure, separate from the first layer; an example of a multi-layering process). Further, as illustrated in FIG. 62 (condition 43), it was also found that a platinum cobalt oxide layer having a delafossite-type crystal structure could be deposited under similar conditions on a sapphire substrate without a palladium cobalt oxide underlayer.

A large RRR (residual resistivity ratio) means that there is less scattering due to defects in the thin film or surface roughness.

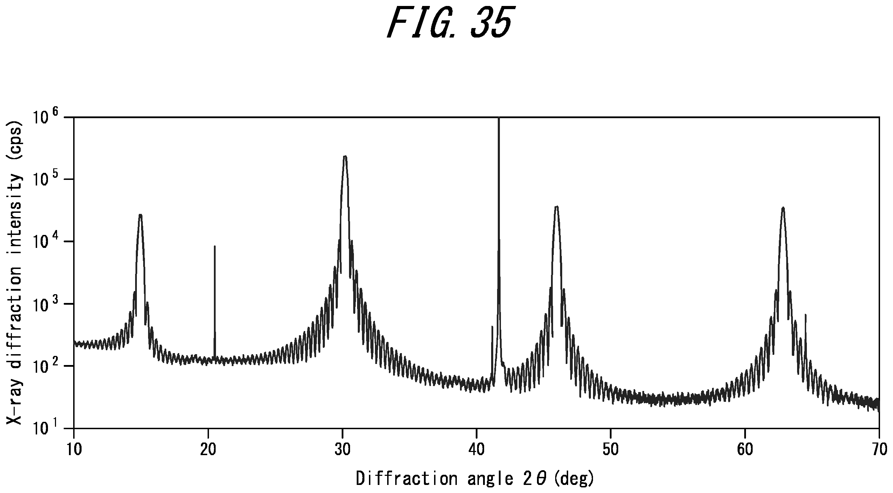

In the X-ray diffraction pattern under condition 31 illustrated in FIG. 35, a clear oscillation of the diffraction intensity is observed in the intermediate region between the 006 diffraction point (30.2°) and the 009 diffraction point (46.1°). This oscillation period is determined by the thickness of the thin film and is called the Laue oscillation, Laue flange, or film thickness flange.

This intensity oscillation is expressed by the Laue function indicated in the following expression 1.

[Math. 1] $L \left(θ\right) = A {\left\{\frac{sin \left(N\frac{2 πd sin θ}{λ}\right)}{sin \left(\frac{2 πd sin θ}{λ}\right)}\right\}}^{2}$ (1)

Here, A is a coefficient, N is the number of planes, d is the interplanar spacing, θ is the diffraction angle, and λ is the wavelength of the X-ray. In a thin film with roughness, functions with different oscillation periods add up and cancel each other out, causing the oscillation to disappear. Further, when the crystallinity is low, the diffraction intensity is weak and no oscillation is observed. For this reason, Laue oscillations are observed only when both the crystallinity and flatness are extremely high.

The delafossite-type oxide is represented by the general formula ABO₂ (A is Pd or Pt, and B is Co, Cr or Rh).

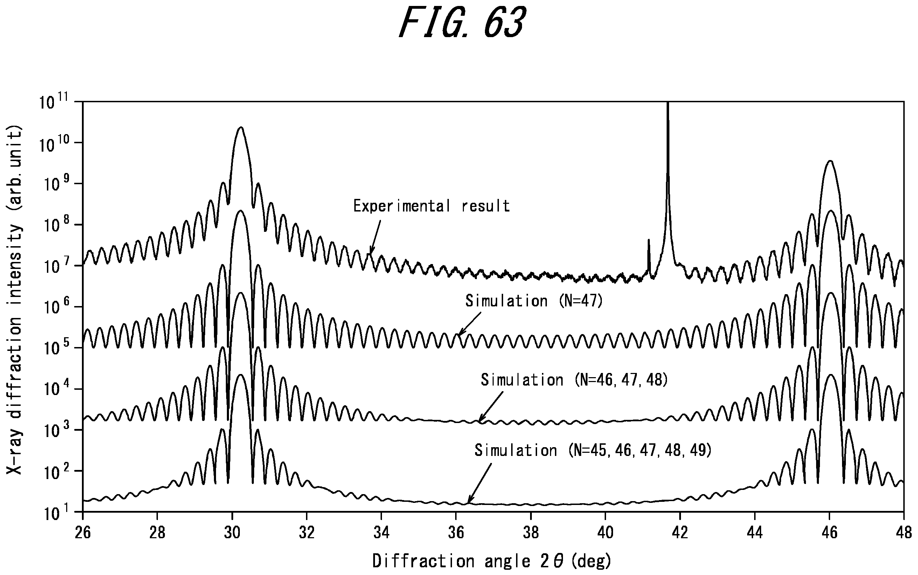

FIG. 63 illustrates a comparison between an enlarged view of the X-ray diffraction pattern of the thin film according to condition 31 (indicated as "Experimental results" in FIG. 63) and simulation results illustrating how the Laue oscillation changes depending on the number N of Pd atomic layers, which is an example of atoms at the A-sites of the delafossite-type oxide.

FIG. 63 illustrates the simulation results for N = 47, where N = 46, 47, and 48 exist with equal probability (when N = 47 is approximately 33 %), and where N = 45, 46, 47, 48, and 49 exist with equal probability (when N = 47 is 20%). Here, as in the X-ray diffraction pattern of the thin film under condition 31, the value of coefficient A was set so that the peak intensities of the 006 diffraction point and the 009 diffraction point were approximately 2000 times the noise level described below. Further, the interplanar spacing d was substituted with 0.591 nm, which is the Pd interlayer distance (=c/3) of PdCoO₂. In FIG. 63, the simulation result for N = 47 is indicated as "Simulation (N = 47)", the simulation result for N = 46, 47, 48 existing with equal probability is indicated as "Simulation (N = 46, 47, 48)", and the simulation result for N = 45, 46, 47, 48, 49 existing with equal probability is indicated as "Simulation (N = 45, 46, 47, 48, 49)".

When the interlayer distance of PdCoO₂ is substituted for the interplanar spacing d as described above, it can be seen that the diffraction pattern of the experimental data can be well reproduced by adding a noise level equivalent to that of the X-ray diffraction pattern of the thin film according to condition 31 to the function for N = 47. Therefore, the number N of A-site layers in the thickness direction of the thin film according to condition 31 is considered to be 47.

In a simulation in which N = 46, 47, and 48 exist with equal probability (N = 47 is approximately 33 %), it can be seen that the oscillation in the region between the 006 diffraction point and the 009 diffraction point is partially suppressed and disappears.

Further, in a simulation in which N = 45, 46, 47, 48, and 49 exist with equal probability (N = 47 is 20 %), the oscillation in the region between the 006 diffraction point and the 009 diffraction point is further suppressed.

In the X-ray diffraction pattern of the thin film according to condition 31, it can be seen that the Laue oscillation in the region between the 006 diffraction point and the 009 diffraction point tends to continue without interruption. Comparing this trend with the results of each simulation, it can be seen that this trend applies between N = 47 (when N = 47 is 100 %) and N = 46, 47, and 48 (when N = 47 is approximately 33 %). Therefore, the thin film according to condition 31 is considered to have high homogeneity with a proportion of N = 47 of 33 % or more, which is considered to contribute to the realization of a high RRR. The thin film according to condition 31 has high homogeneity with a proportion of N = 47 of 33 % or more, which means that 33 % or more of the area of the thin film is made up of 47 A-site layers, which is the same number as the number of A-site layers in the thickness direction of the thin film according to condition 31. Thus, from the results of the thin film under condition 31, when the number of A-site layers in the thickness direction is N, a high RRR is achieved when 33 % or more of the area of the thin film has the same N.

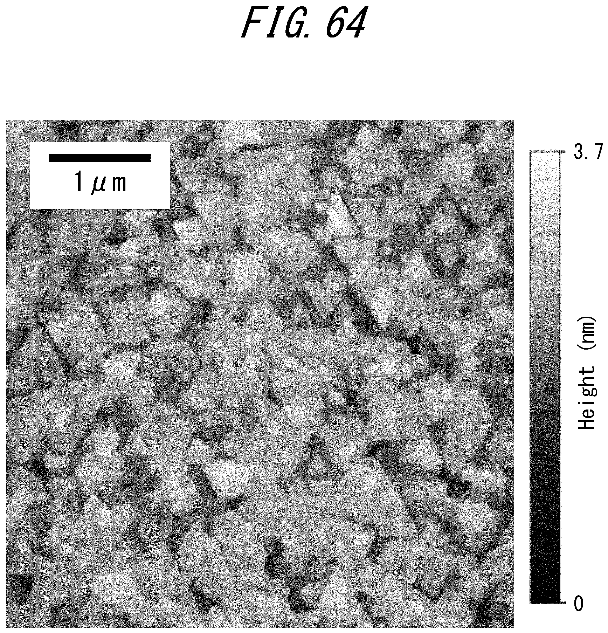

FIG. 64 illustrates a topography image (atomic force microscope image) of the thin film according to condition 31 measured with an atomic force microscope. In this topographic image, triangular or hexagonal crystal facets, which are derived from the trigonal crystal structure of delafossite, are observed. Such crystal facets are generally observed when the sample is highly crystalline.

From the measurement results of the topography image illustrated in FIG. 64, it can be seen that the surface of the thin film according to condition 31 is flat, with the root mean square (RMS) of the surface roughness height in the thickness direction being 0.35 nm (less than 0.4 nm). In the thin film according to condition 31, the flatness of the surface is believed to contribute to the high RRR.

Thus, the thin film according to condition 31 has a structural feature that 33 % or more of the area of the thin film is homogeneous with the same N, the RMS is 0.4 nm or less, the surface has little roughness, and the clear triangular or hexagonal crystal facets observed in the thin film indicate that the thin film has high crystallinity. The thin film according to condition 31 achieves a high RRR due to these characteristics. This is also believed to be true for other delafossite-type oxide thin films (oxide thin films having a delafossite-type crystal structure) according to the present embodiment.

In this way, a method of producing a delafossite-type oxide thin film can be provided.

The embodiments disclosed herein are illustrative, and variations as appropriate within the scope of the present disclosure may be made without being limited to the disclosed embodiments.

### INDUSTRIAL APPLICABILITY

The present disclosure can be applied to a method of producing a delafossite-type oxide thin film and to an oxide thin film.

## Claims

1. A method of producing a delafossite-type oxide thin film, the method comprising a film formation process of forming a thin film by physical vapor deposition using a target containing a first metal and a second metal, wherein
the first metal is palladium or platinum, and
the second metal is cobalt, chromium, or rhodium.

2. The method of producing a delafossite-type oxide thin film according to claim 1,
wherein the first metal is contained in an amount of 45 at% or more and 90 at% or less,
the balance being the second metal and impurity,
wherein the content of the impurity is 500 mass ppm or less,
wherein the content of oxygen as the impurity is 200 mass ppm or less.

3. The method of producing a delafossite-type oxide thin film according to claim 1 or 2, further comprising a sintering process of producing the target by sintering a metal powder containing 45 at% or more and 90 at% or less of the first metal, with the balance being the second metal and impurity.

4. The method of producing a delafossite-type oxide thin film according to claim 3, wherein the metal powder is an alloy powder of the first metal and the second metal.

5. The method of producing a delafossite-type oxide thin film according to any one of claims 1 to 4, wherein, in the film formation process, the pressure of the atmosphere is 0.5 Pa or less when the thin film is formed.

6. The method of producing a delafossite-type oxide thin film according to any one of claims 1 to 5, wherein, in the film formation process, a ratio of oxygen to argon in the atmosphere is 2 or more and 4 or less when the thin film is formed.

7. The method of producing a delafossite-type oxide thin film according to any one of claims 1 to 6, wherein, in the film formation process, a temperature of a substrate on which the thin film is formed is 500 °C or higher and 850 °C or lower when the thin film is formed.

8. The method of producing a delafossite-type oxide thin film according to any one of claims 1 to 6, wherein, in the film formation process, a temperature of a substrate on which the thin film is formed is 610 °C or higher and 800 °C or lower when the thin film is formed.

9. The method of producing a delafossite-type oxide thin film according to any one of claims 1 to 4, wherein, in the film formation process,
the pressure of the atmosphere is 0.5 Pa or less when the thin film is formed,
the ratio of oxygen to argon in the atmosphere is 2 or more and 7 or less when the thin film is formed, and
a temperature of a substrate on which the thin film is formed is 500 °C or higher and 850 °C or lower when the thin film is formed.

10. The method of producing a delafossite-type oxide thin film according to any one of claims 1 to 8, wherein the target contains the first metal in an amount of 45 at% or more and 60 at% or less.

11. The method of producing a delafossite-type oxide thin film according to any one of claims 1 to 10, wherein the film formation process comprises a multi-layering process of stacking, on a first layer having a delafossite-type crystal structure, a second layer having a delafossite-type crystal structure that is different from the first layer.

12. An oxide thin film comprising a delafossite-type crystal structure, and having a residual resistivity ratio, which is a value obtained by dividing the electrical resistivity at 300 K by the electrical resistivity at 2 K, of 1.0 or more and 8.0 or less.

13. The oxide thin film according to claim 12, wherein the residual resistivity ratio is 3.0 or more and 8.0 or less.

14. The oxide thin film according to claim 12 or 13, having a film thickness of 7.0 nm or more and 165.0 nm or less.

15. The oxide thin film according to claim 12 or 13, having a film thickness of 30 nm or more.

16. The oxide thin film according to any one of claims 12 to 15, comprising a first layer having a delafossite-type crystal structure; and
a second layer having a delafossite-type crystal structure that is different from the first layer and is stacked on the first layer.

17. The oxide thin film according to claim 12 or 13, wherein when a number of A-site layers in the thickness direction is N, regions having the same N account for 33 % or more of the area of the thin film.

18. The oxide thin film according to claim 12 or 13, wherein triangular or hexagonal crystal facets appear on the surface, and the root mean square of the surface roughness height is 0.4 nm or less.

19. An oxide thin film comprising a delafossite-type crystal structure, and when a number of A-site layers in the thickness direction is N, regions having the same N account for 33 % or more of the area of the thin film.

20. An oxide thin film comprising a delafossite-type crystal structure, wherein triangular or hexagonal crystal facets appear on the surface, and the root mean square of the surface roughness height in the thickness direction is 0.4 nm or less.
